# EUROPEAN PATENT APPLICATION

(11) **EP 4 316 845 A1**
(43) Date of publication of application: **07.02.2024**
(21) Application number: 22780788.0
(22) Date of filing: 28.03.2022
(51) Int. Cl.: B41C 1/00, B41N 1/00, G03F 7/00, G03F 7/095

(54) **FLEXOGRAPHIC PRINTING ORIGINAL PLATE, AND METHOD FOR MANUFACTURING FLEXOGRAPHIC PRINTING PLATE**

(30) Priority: 30.03.2021 JP 2021056654
(71) Applicant: Asahi Kasei Kabushiki Kaisha, Tokyo 1000006 (JP)
(72) Inventor: TOYOOKA, Sota, Tokyo 100-0006 (JP); FUJIKI, Yuzo, Tokyo 100-0006 (JP); MIYAMOTO, Shinji, Tokyo 100-0006 (JP)
(74) Representative: Strehl Schübel-Hopf & Partner
(86) International application number: PCT/JP2022/015118
(87) International publication number: WO 2022/210577

(57) **Abstract**

A flexographic printing raw plate including:
a support;
a photosensitive resin composition layer on the support;
an intermediate layer; and
an infrared ablation layer in the presented order, wherein
in a tensile stress-strain curve diagram measured by molding the intermediate layer into dumbbell shape No. 8 with a thickness of 100 µm in accordance with JIS K 6251 (2017),
an elongation at a breaking point is 5% or more and 200% or less,
an elongation at a point where the stress is maximized is 3% or more and 200% or less, and
a maximum value of the stress is 1.0 MPa or more and 15 MPa or less.

## Description

### Technical Field

The present invention relates to a flexographic printing raw plate and a manufacturing method of a flexographic printing plate.

### Background Art

In recent years, CTP (computer to plate) technology has developed and become general in the field of flexographic printing. In the CTP technology, a sheet in which a photosensitive resin composition layer, an intermediate layer, an infrared ablation layer, and a cover film are stacked in sequence on a substrate made of, for example, PET resin is usually used as a raw plate for flexographic printing plate manufacturing.

Manufacturing of a flexographic printing plate by use of CTP technology is carried out in the following manner, for example. Firstly, a uniform cured layer is formed by performing back exposure in which the entire surface of a photosensitive resin composition layer is irradiated with ultraviolet light through a substrate of a film of PET resin or the like. Then, a cover film on an infrared ablation layer is peeled to expose the infrared ablation layer, on which lithography is performed by irradiation with a laser to remove a part of the infrared ablation layer, thereby producing an image mask. Furthermore, relief exposure in which the photosensitive resin composition layer is irradiated with ultraviolet light through the image mask is performed to photocure the part at which the infrared ablation layer has been removed. Thereafter, the unnecessary unexposed part (that is, the part not photocured) of the infrared ablation layer, an intermediate layer, and the photosensitive resin composition layer is dissolved or swollen in a developer and removed by the application of external force with a brush or the like to form a relief image, which is a desired image, and a flexographic printing plate is thus obtained.

In the manufacturing of a flexographic printing plate as described above, it is important for the infrared ablation layer to have no defect (hereinafter, also referred to as pinhole or PH). If the infrared ablation layer has pinholes, the photosensitive resin composition layer in contact with the pinholes is exposed in relief exposure. Therefore, the formation of an unintended image occurs, causing a problem of formation of a relief with a large relief image against the intent.

Examples of the method for providing an infrared ablation layer on a photosensitive resin composition layer include a method of directly applying the infrared ablation layer to the photosensitive resin composition layer as well as a method of applying the infrared ablation layer onto a cover sheet, laminating the infrared ablation layer side with the photosensitive resin composition layer, and stacking them by transfer.

However, a problem of these methods is the risk of causing pinholes due to impact during storage or transport of the cover sheet on which the infrared ablation layer has been applied, and furthermore, due to a lamination temperature or pressure upon lamination with the photosensitive resin composition layer, or contact with a kneaded extruded resin.

In light of such a problem, Patent Literature 1 has proposed a flexographic printing raw plate in which an intermediate layer constituted by a water-dispersible latex is provided between the photosensitive resin composition layer and the infrared ablation layer mentioned above. An intermediate layer of a soft and heat-resistant water-dispersible latex is provided on the infrared ablation layer, which can thereby be protected from impact during storage or transport of the cover sheet or from a lamination temperature or pressure upon lamination with the photosensitive resin composition layer, and inhibited from generating pinholes.

It is also important for the infrared ablation layer to have low tackiness. However, a low-molecular-weight component in a photosensitive resin composition might unintentionally migrate to the infrared ablation layer during storage of the flexographic printing raw plate, thereby increasing the tackiness of the infrared ablation layer.

Increased tackiness of the infrared ablation layer increases adhesion strength between a cover film and the infrared ablation layer when the cover film is peeled to expose the infrared ablation layer at the time of manufacturing of a flexographic printing plate. Thus, the peeling of the cover film cannot be normally performed, and pinholes might be caused.

When an unexposed part in a photosensitive resin composition layer is removed at the time of manufacturing of a flexographic printing plate, a trouble of reattachment of scums of an infrared ablation layer onto a relief image might arise.

In view of such a problem, establishment of an intermediate layer between an infrared ablation layer and a photosensitive resin composition layer using a highly crystalline material is effective for preventing mass transfer between the photosensitive resin composition layer and the infrared ablation layer. For example, Patent Literature 2 has proposed an intermediate layer constituted by polyvinyl alcohol resin. Also, Patent Literature 3 has proposed an intermediate layer constituted by polyvinyl alcohol resin and polyamide resin. These intermediate layers also prevent supply of oxygen in the atmosphere to a photosensitive resin composition layer and enable a relief image to be stably formed.

### Citation List

### Patent Literature

Patent Literature 1: Japanese Patent Laid-Open No. 2020-140182
Patent Literature 2: Japanese Patent Laid-Open No. 2013-156495
Patent Literature 3: Japanese Patent Laid-Open No. 2020-46568

### Summary of Invention

### Technical Problem

Although the water-dispersible latex resin proposed in Patent Literature 1 has softness and high scratch resistance and can inhibit pinholes, there arises a problem that the intermediate layer, because of being hydrophobic, is difficult to dissolve or swell in an aqueous developer and is difficult to remove at the time of development.

Although the polyvinyl alcohol resin proposed in Patent Literature 2 and the polyamide resin proposed in Patent Literature 3 have good heat resistance and furthermore, because of being hydrophilic, have good solubility in an aqueous developer and permit rapid development, there arise a problem that these resins intrinsically tend to take up water due to their crystal structures derived from a hydrogen bond, and increase the plasticity of the intermediate layer when stored under high humidity.

Increased plasticity of the intermediate layer reduces a function of preventing mass transfer and increases the tackiness of the infrared ablation layer, and a trouble of reattachment of development scums of the infrared ablation layer onto a relief image might arise. Furthermore, the ability to block oxygen in the atmosphere is reduced, and there arises a problem that a formed relief image is smaller than a desired size.

Therefore, giving consideration to the problems in conventional techniques, the present invention aims at providing a flexographic printing raw plate that enables an infrared ablation layer and an intermediate layer to be rapidly removed at the time of development, stabilizes the size of a relief image regardless of a preservation environment, and is free from reattachment of development scums of the infrared ablation layer, and a manufacturing method of a flexographic printing plate using the flexographic printing raw plate.

### Solution to Problem

The present inventors have made intensive studies to solve the above-described problems, and as a result, found that the problems can be solved by a flexographic printing raw plate having an intermediate layer having tensile physical properties in a predetermined numeric range; thus, the present invention has been accomplished.

Specifically, the present invention is as follows.
[1] A flexographic printing raw plate comprising:
   a support;
   a photosensitive resin composition layer on the support;
   an intermediate layer; and
   an infrared ablation layer in the presented order, wherein
   in a tensile stress-strain curve diagram measured by molding the intermediate layer into dumbbell shape No. 8 with a thickness of 100 µm in accordance with JIS K 6251 (2017),
   an elongation at a breaking point is 5% or more and 200% or less,
   an elongation at a point where the stress is maximized is 3% or more and 200% or less, and
   a maximum value of the stress is 1.0 MPa or more and 15 MPa or less.
[2] The flexographic printing raw plate according to [1], wherein
   the intermediate layer has a water contact angle of 60° or more and 90° or less 3 minutes after dropwise addition at an interface with the infrared ablation layer.
[3] The flexographic printing raw plate according to [1] or [2], wherein
   the intermediate layer has a water contact angle of 70° or more 3 minutes after dropwise addition at an interface with the infrared ablation layer.
[4] A flexographic printing raw plate comprising:
   a support;
   a photosensitive resin composition layer on the support;
   an intermediate layer; and
   an infrared ablation layer in the presented order, wherein
   the intermediate layer has a water contact angle of 70° or more and 90° or less 3 minutes after dropwise addition at an interface with the infrared ablation layer.
[5] The flexographic printing raw plate according to any one of [1] to [4], wherein
   the intermediate layer comprises 10% by mass or more and 95% by mass or less of an emulsion compound (A) having a glass transition temperature (Tg) of 30°C or higher based on the total amount of the intermediate layer.
[6] The flexographic printing raw plate according to [5], wherein
   an acid value of the emulsion compound (A) is 20 mg KOH/g or more and 100 mg KOH/g or less.
[7] The flexographic printing raw plate according to [5] or [6], wherein
   a number average molecular weight of the emulsion compound (A) is 2,000 or more and 50,000 or less.
[8] The flexographic printing raw plate according to any one of [1] to [7], wherein
   the emulsion compound (A) comprises a polyester emulsion.
[9] The flexographic printing raw plate according to [8], wherein
   the emulsion compound (A) is a co-polyester emulsion comprising an aromatic polyvalent carboxylic acid component as a copolymer component and having a carboxyl group and/or a sulfonate group.
[10] The flexographic printing raw plate according to any one of [1] to [9], wherein
   the intermediate layer further comprises 10% by mass or more and 70% by mass or less of an emulsion compound (B) having a glass transition temperature (Tg) of 10°C or lower based on the total amount of the intermediate layer.
[11] The flexographic printing raw plate according to [10], wherein
   the emulsion compound (B) is at least one emulsion compound selected from the group consisting of a polyurethane emulsion, a polybutadiene latex, a styrene-butadiene copolymer latex, and an acrylonitrile-butadiene copolymer latex.
[12] The flexographic printing raw plate according to [10] or [11], wherein
   a ratio of the emulsion compound (A) to the emulsion compound (B) is 1.0 or more and 2.3 or less.
[13] The flexographic printing raw plate according to any one of [1] to [12], wherein
   the intermediate layer further comprises a layered inorganic compound (C).
[14] The flexographic printing raw plate according to any one of [1] to [13], wherein
   the intermediate layer further comprises a crosslinking agent (D).
[15] The flexographic printing raw plate according to any one of [1] to [14], wherein
   a thickness of the intermediate layer is larger than 2 µm and 30 µm or less.
[16] A manufacturing method of a flexographic printing plate, comprising:
   an infrared irradiation step of producing a negative pattern by subjecting the infrared ablation layer of the flexographic printing raw plate according to any one of [1] to [15] to laser ablation;
   an exposure step of selectively exposing the photosensitive resin composition layer through the negative pattern; and
   a development step of removing an unexposed part of the photosensitive resin composition layer.
[17] A flexographic printing method comprising:
   a printing plate manufacturing step of manufacturing a flexographic printing plate by the manufacturing method of a flexographic printing plate according to [16]; and
   a step of performing printing using the flexographic printing plate manufactured in the printing plate manufacturing step.

### Advantageous Effects of Invention

According to the present invention, a flexographic printing raw plate that enables an infrared ablation layer and an intermediate layer to be rapidly removed at the time of development, stabilizes the size of a relief image regardless of a preservation environment, and is free from reattachment of development scums of the infrared ablation layer, and a manufacturing method of a flexographic printing plate using the flexographic printing raw plate can be provided.

### Brief Description of Drawings

[Figure 1] Figure 1 shows a schematic cross-sectional view of the flexographic printing raw plate of the present embodiment.
[Figure 2] Figure 2 shows a schematic view showing a manufacturing method of a flexographic printing plate using the flexographic printing raw plate of the present embodiment.
[Figure 3] Figure 3 shows a schematic view showing another form of a manufacturing method of a flexographic printing plate using the flexographic printing raw plate of the present embodiment.
[Figure 4] Figure 4 shows a tensile stress-strain curve diagram of Examples 2 and 6 and Comparative Example 1.
[Figure 5] Figure 5 shows the tensile stress-strain curve diagram of Example 2.
[Figure 6] Figure 6 shows the tensile stress-strain curve diagram of Example 6.
[Figure 7] Figure 7 shows the tensile stress-strain curve diagram of Comparative Example 1.

### Description of Embodiment

Hereinafter, a mode for carrying out the present invention will be described in detail. However, the present invention is not limited thereto, and various modifications can be made without departing from the spirit of the present invention. Hereinafter, flexographic printing raw plates of the first embodiment and the second embodiment will be described. These embodiments, if not particularly distinguished, are referred to as the "present embodiment".

### 1. First embodiment: flexographic printing raw plate

The flexographic printing raw plate of the first embodiment comprises a support, a photosensitive resin composition layer on the support, an intermediate layer, and an infrared ablation layer in the presented order, wherein in a tensile stress-strain curve diagram measured by molding the intermediate layer into dumbbell shape No. 8 with a thickness of 100 µm in accordance with JIS K 6251 (2017), an elongation at a breaking point is 5% or more and 200% or less, an elongation at a point where the stress is maximized is 3% or more and 200% or less, and a maximum value of the stress is 1.0 MPa or more and 15 MPa or less.

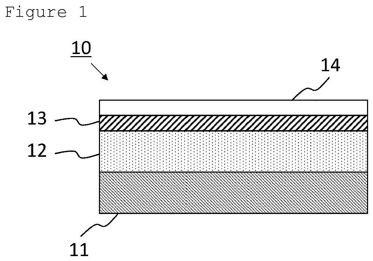

Figure 1 shows a schematic cross-sectional view of the flexographic printing raw plate of the first embodiment. In flexographic printing raw plate 10 of the first embodiment, support 11, photosensitive resin composition layer 12 on which a concave-convex pattern of a flexographic printing plate is formed, intermediate layer 13 which prevents pinholes on an infrared ablation layer, and infrared ablation layer 14 which functions as a mask at the time of forming a concave-convex pattern of a flexographic printing plate are sequentially stacked. A functional layer such as an adhesive layer may be provided between these layers as needed. Hereinafter, the configuration of the flexographic printing raw plate of the first embodiment will be described in detail.

### 1.1. Support

The support used for the flexographic printing raw plate of the first embodiment is not particularly limited, and examples thereof include a polypropylene film, a polyethylene film, a film of a polyester such as polyethylene terephthalate and polyethylene naphthalate, and a polyamide film. Among them, a polyester film is preferable as the support.

The thickness of the support is preferably 50 µm to 300 µm.

In addition, an adhesive layer may be provided between the support and the photosensitive resin composition layer for the purpose of increasing adhesive strength between the support and the photosensitive resin composition layer.

The material for the adhesive layer is not particularly limited, and examples thereof include a composition having a binder polymer such as polyurethane, polyamide, and a thermoplastic elastomer and an adhesive active ingredient such as an isocyanate compound and an ethylenically unsaturated compound.

Furthermore, various auxiliary additive components such as a plasticizer, a thermal-polymerization preventing agent, an ultraviolet absorber, a halation preventing agent, a photostabilizer, a photopolymerization initiator, a photopolymerizable monomer, and a dye can be added to the adhesive layer.

At least one or more undercoating layers may be provided between the adhesive layer and the support for the purpose of further increasing adhesive strength between the adhesive layer and the support.

### 1.2. Photosensitive resin composition layer

The photosensitive resin composition layer that constitutes the flexographic printing raw plate of the first embodiment is useful in all of solvent development, water development, and heat development.

Preferable examples of material for the photosensitive resin composition layer are not particularly limited, and include a photosensitive resin composition including a thermoplastic elastomer (a-1), a photopolymerizable monomer (a-3), and a photopolymerization initiator (a-4). In addition to these major components, the photosensitive resin composition layer may optionally include a liquid diene (a-5), silicone compound (a-6) and others.

In the case of performing a development step in an aqueous developer, the photosensitive resin composition layer preferably further includes polymer particles (a-2) .

These components (a-1) to (a-6) will be described below in detail. Those described in "Japanese Patent Laid-Open No. 2018-120131" can be used as these compounds, for example.

1.2.1. Thermoplastic elastomer (a-1)

The thermoplastic elastomer( a-1) is not particularly limited, and examples thereof include a thermoplastic elastomer having a constituent unit derived from conjugated diene and/or vinyl aromatic hydrocarbon. The thermoplastic elastomer may be a homopolymer or a copolymer. In the case of a copolymer, the thermoplastic elastomer may be a random copolymer or a block copolymer.

Among them, a thermoplastic elastomer containing at least one polymer block including mainly a conjugated diene and at least one polymer block including mainly a vinyl aromatic hydrocarbon is preferable.

The term "including mainly" used herein means that 60% by mass or more of the polymer block is constituted by a predetermined monomer.

In the polymer block including mainly a conjugated diene, the content of the conjugated diene unit is preferably 80% by mass or more and more preferably 90% by mass or more of the polymer block.

The conjugated diene is not particularly limited, and examples thereof include monomers such as 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene. Among them, 1,3-butadiene is especially preferable in view of abrasion resistance. These monomers may be used singly or in combinations of two or more thereof.

A vinyl content in the polymer block including mainly the conjugated diene is preferably 5 to 50 mol%, more preferably 8 to 50 mol%, and still more preferably 10 to 40 mol% based on the total amount of the conjugated diene unit in view of printing plate formability. The "vinyl content" herein refers to a content of 1,2-butadiene or 3,4-isoprene, for example.

A number average molecular weight of the polymer block including mainly the conjugated diene is preferably 20,000 to 250,000, more preferably 30,000 to 200,000, and still more preferably 40,000 to 150,000 in view of wear resistance of the plate.

The polymer block including mainly the conjugated diene may contain an alkylene unit. An introducing method of the alkylene unit is not particularly limited, and examples thereof include a method involving polymerization using a monoolefin such as ethylene and butylene as a starting material monomer of the polymer block including mainly the conjugated diene, and a method involving hydrogenating conjugated diene polymer block. Especially, a method involving hydrogenating polymer block including mainly the conjugated diene is preferable in view of availability.

The content of the alkylene unit in the polymer block including mainly the conjugated diene is preferably 5 to 50 mol%, more preferably 10 to 35 mol%, and still more preferably 10 to 25 mol% based on the total amount of monomer units included in the polymer block. When the content of the alkylene unit is 5 mol% or more, solvent resistance tends to more improve. When the content of the alkylene unit is 50 mol% or less, transparency of the photosensitive resin composition layer tends to more improve.

The polymer block including mainly conjugated diene preferably contains an alkylene unit and more preferably all of a 1,4-butadiene unit, a 1,2-butadiene (vinyl) unit, and a butylene (alkylene) unit. In this respect, it is further preferable that the polymer block including mainly conjugated diene contain 25 to 70 mol% of a 1,4-butadiene unit, 0 to 50 mol% of a 1,2-butadiene (vinyl) unit, and 10 to 50 mol% of a butylene unit. Such a polymer block can be obtained by hydrogenating the polymer block moiety including mainly butadiene.

The conjugated diene content, the vinyl content in the conjugated diene, and the content and ratio of the vinyl aromatic hydrocarbon can be measured using a nuclear magnetic resonance device (¹H-NMR).

The vinyl aromatic hydrocarbon is not particularly limited, and examples thereof include monomers such as styrene, t-butylstyrene, divinylbenzene, 1,1-diphenylstyrene, N,N-dimethyl-p-aminoethyl styrene, N,N-diethyl-p-aminoethyl styrene, vinylpyridine, p-methylstyrene, tertiary butylstyrene, α-methylstyrene, and 1,1-diphenylethylene. Especially, styrene is preferable because a flexographic printing raw plate with smoothness can be formed at a relatively low temperature (hereinafter, also referred to as "high smoothness"). These monomers may be used singly, or in combinations of two or more thereof.

A number average molecular weight of the polymer block including mainly the vinyl aromatic hydrocarbon is preferably 100,000 or less in view of preventing orientation of a printing plate from being exhibited and is preferably 3,000 or more in view of chipping resistance during plate making and printing. The number average molecular weight of the polymer block including mainly the vinyl aromatic hydrocarbon is more preferably 5,000 to 80,000 and still more preferably 5,000 to 60,000.

The content of the vinyl aromatic hydrocarbon in the block copolymer is preferably 13 to 25% by mass, more preferably 15 to 24% by mass, and still more preferably 16 to 23% by mass based on the total amount of the block copolymer. When the content of the vinyl aromatic hydrocarbon is 25% by mass or less, high smoothness of the photosensitive resin composition, high chipping resistance at a convex part of the printing plate, and hardness of the printing plate kept high when an ink component attaches thereto tend to be attained. On the other hand, when the content of the vinyl aromatic hydrocarbon is 13% by mass or more, cold flow resistance of the flexographic printing raw plate tends to more improve.

The content of the thermoplastic elastomer (a-1) in the photosensitive resin composition layer is preferably 15 to 90% by mass, more preferably 15 to 80% by mass and still more preferably 20 to 75% by mass based on 100% by mass of the total amount of the photosensitive resin composition in view of wear resistance of the plate during printing.

### 1.2.2. Polymer particles (a-2)

The polymer particles (a-2) are internally-crosslinked polymer particles of a monomer. Such polymer particles are not particularly limited, and examples thereof include those obtained by preparing a water-dispersion latex in which polymer particles as a dispersoid are dispersed in water by emulsion polymerization, and removing water from the obtained water-dispersion latex.

The monomer that constitutes the polymer particles (a-2) is not particularly limited as long as it has a polymerizable double bond. Examples thereof include monobasic acid monomers, polybasic acid monomers, conjugated dienes, aromatic vinyl compounds, (meth)acrylic acid esters, monomers having a hydroxy group, unsaturated dibasic acid alkyl esters, maleic anhydride, vinyl cyanide compounds, (meth)acrylamides and derivatives thereof, vinyl esters, vinyl ethers, vinyl halides, basic monomers having an amino group, vinylpyridine, olefins, silicon-containing α,β-ethylenically unsaturated monomers, and allyl compounds. The monomer that constitutes the polymer particles (a-2) may include a reactive emulsifier for use in emulsion polymerization described later.

The monobasic acid monomers are not particularly limited, and examples thereof include monomers having a carboxyl group, such as acrylic acid, methacrylic acid, crotonic acid, vinylbenzoic acid, and cinnamic acid; and monomers having a sulfonic acid group, such as styrenesulfonic acid.

The content of the monobasic acid monomer is preferably 1 to 30% by mass, more preferably 2 to 20% by mass, still more preferably 3 to 15% by mass, and further preferably 5 to 10% by mass based on the total amount of the polymer particles (a-2).

The polybasic acid monomers are not particularly limited, and examples thereof include monomers having two or more carboxyl groups, such as itaconic acid, fumaric acid, maleic acid, citraconic acid, and muconic acid; and monomers having a polybasic acid group of a phosphoric acid group.

The conjugated dienes are not particularly limited, and examples thereof include 1,3-butadiene, isoprene, 2,3-dimethyl-1,3-butadiene, 2-ethyl-1,3-butadiene, 2-methyl-1,3-butadiene, 1,3-pentadiene, chloroprene, 2-chloro-1,3-butadiene, and cyclopentadiene.

The content of the conjugated diene is preferably 45 to 75% by mass, more preferably 50 to 70% by mass, and still more preferably 55 to 65% by mass based on the total amount of the polymer particles (a-2).

The aromatic vinyl compounds are not particularly limited, and examples thereof include styrene, α-methylstyrene, o-methylstyrene, m-methylstyrene, p-methylstyrene, ethylstyrene, vinyltoluene, vinylxylene, bromostyrene, vinylbenzyl chloride, p-t-butylstyrene, chrolostyrene, alkylstyrene, divinylbenzene, and trivinylbenzene.

The content of the aromatic vinyl compound is preferably 3 to 25% by mass, more preferably 5 to 20% by mass, and still more preferably 7.5 to 15% by mass based on the total amount of the polymer particles (a-2).

Examples of the (meth)acrylic acid esters include, but not particularly limited to, methyl (meth)acrylate, ethyl (meth)acrylate, propyl (meth)acrylate, n-butyl (meth)acrylate, t-butyl (meth)acrylate, isobutyl (meth)acrylate, n-amyl (meth)acrylate, isoamylhexyl (meth)acrylate, octyl (meth)acrylate, nonyl (meth)acrylate, decyl (meth)acrylate, dodecyl (meth)acrylate, octadecyl (meth)acrylate, cyclohexyl (meth)acrylate, phenyl (meth)acrylate, benzyl (meth)acrylate, 2-ethyl-hexyl (meth)acrylate, glycidyl (meth)acrylate, ethylene glycol di(meth)acrylate, ethylene glycol di(meth)acrylate, 1,3-butylene glycol di(meth)acrylate, 1,4-butylene glycol di(meth)acrylate, propylene glycol di(meth)acrylate, 1,5-pentanediol di(meth)acrylate, neopentyl glycol di(meth)acrylate, 1,6-hexanediol di(meth)acrylate, diethylene glycol di(meth)acrylate, triethylene glycol di(meth)acrylate, tetraethylene glycol di(meth)acrylate, polyethylene glycol di(meth)acrylate, polypropylene glycol di(meth)acrylate, pentaerythritol tri(meth)acrylate, trimethylolpropane tri(meth)acrylate, tetramethylolmethane tetra(meth)acrylate, allyl (meth)acrylate, bis(4-acryloxypolyethoxyphenyl)propane, methoxy polyethylene glycol (meth)acrylate, β-(meth)acryloyloxy ethylhydrogenphthalate, β-(meth)acryloyloxy ethylhydrogensuccinate, 3-chloro-2-hydroxypropyl (meth)acrylate, stearyl (meth)acrylate, phenoxyethyl (meth)acrylate, phenoxypolyethyleneglycol (meth)acrylate, 2-hydroxy-1,3-di(meth)acryloxypropane, 2,2-bis[4-((meth)acryloxyethoxy)phenyl]propane, 2,2-bis[4-((meth)acryloxy-diethoxy)phenyl]propane, 2,2-bis[4-((meth)acryloxy-polyethoxy)phenyl]propane, and isobornyl (meth)acrylate.

The content of the (meth)acrylic acid ester is preferably 10 to 35% by mass, more preferably 15 to 30% by mass, and still more preferably 20 to 25% by mass based on the total amount of the polymer particles (a-2).

The monomers having a hydroxy group are not particularly limited, and examples thereof include ethylene-based monocarboxylic acid alkyl ester monomers such as 2-hydroxyethyl acrylate, 2-hydroxyethyl methacrylate, 2-hydroxypropyl acrylate, 2-hydroxypropyl methacrylate, 1-hydroxypropyl acrylate, 1-hydroxypropyl methacrylate, and hydroxycyclohexyl (meth)acrylate.

Examples of the unsaturated dibasic acid alkyl esters include, but not particularly limited to, alkyl crotonates, alkyl itaconates, alkyl fumarates, and alkyl maleates.

Examples of the vinyl cyanide compounds include, but not particularly limited to, acrylonitrile and methacrylonitrile.

Examples of the (meth)acrylamides and derivatives thereof include, but not particularly limited to, (meth)acrylamide, N-methylol (meth)acrylamide, and N-alkoxy (meth)acrylamide.

Examples of the vinyl esters include, but not particularly limited to, vinyl acetate, vinyl butyrate, vinyl stearate, vinyl laurate, vinyl myristate, vinyl propionate, and vinyl ester of versatic acid.

Examples of the vinyl ethers include, but not particularly limited to, methyl vinyl ether, ethyl vinyl ether, propyl vinyl ether, butyl vinyl ether, amyl vinyl ether, and hexyl vinyl ether.

Examples of the vinyl halides include, but not particularly limited to, vinyl chloride, vinyl bromide, vinyl fluoride, vinylidene chloride, and vinylidene fluoride.

Examples of the basic monomers having an amino group include, but not particularly limited to, aminoethyl (meth)acrylate, dimethylaminoethyl (meth)acrylate, and diethylaminoethyl (meth)acrylate.

Examples of the olefins include, but not particularly limited to, ethylene.

Examples of the silicon-containing α,β-ethylenically unsaturated monomers include, but not particularly limited to, vinyltrichlorosilane and vinyltriethoxysilane.

Examples of the allyl compounds include, but not particularly limited to, allyl esters and diallyl phthalates.

Besides, a monomer having three or more double bonds such as triallyl isocyanurate can be also used.

These monomers may be used singly, or two or more thereof may be mixed and used. In particular, it is preferable to include a monomer having an acidic group (hereinafter, also simply referred to as an "acidic monomer") such as a monobasic acid monomer or a polybasic acid monomer, and a monomer having a hydrophobic group (hereinafter, also simply referred to as a "hydrophobic monomer") such as conjugated diene, an aromatic vinyl compound, or a (meth)acrylic acid ester. The conjugated diene, the aromatic vinyl compound, and the (meth)acrylic acid ester that correspond to the hydrophobic monomer have a hydrocarbon group, and those having a hydrophilic group such as a hydroxy group are excluded from the hydrophobic monomer even if they are a (meth)acrylic acid ester or the like.

The content of the acidic monomer is preferably 1 to 30% by mass, more preferably 2 to 20% by mass, still more preferably 3 to 15% by mass, and further preferably 5 to 10% by mass based on the total amount of the polymer particles (a-2). When the content of the acidic monomer is 1% by mass or more, aqueous developing performance tends to more improve. When the content is 30% by mass or less, an increase in the amount of moisture absorbed by the photosensitive resin composition and an increase in swelling by ink can be prevented, and deterioration in processability during mixing the photosensitive resin composition can be prevented.

The content of the monomer having a hydrophobic group is preferably 70 to 99% by mass, more preferably 80 to 98% by mass, still more preferably 85 to 97% by mass, and further preferably 90 to 95% by mass. When the polymer particles (a-2) has such composition, rubber elasticity of the photosensitive resin composition tends to more improve.

The polymer included in the polymer particles (a-2) is not particularly limited, and examples thereof include polymers having a butadiene skeleton, such as polybutadiene, an acrylonitrile-butadiene copolymer, a styrene-butadiene copolymer, and a (meth)acrylate-butadiene copolymer; polymers having an isoprene skeleton, such as polyisoprene and polychloroprene; polymers obtained by further polymerizing a monomer having a carboxyl group and/or a hydroxy group with the polymers having butadiene skeleton or an isoprene skeleton; polymers obtained by further polymerizing a (meth)acrylic acid ester with the polymers having butadiene skeleton or an isoprene skeleton; polymers obtained by further polymerizing a (meth)acrylic acid ester and a monomer having a carboxyl group and/or a hydroxy group with the polymers having butadiene skeleton or an isoprene skeleton; and polyurethane, a vinylpyridine polymer, a butyl polymer, a Thiokol polymer, an acrylate polymer, and natural rubber.

The monomer having a carboxyl group herein means the monobasic acid monomer and/or the polybasic acid monomer.

Among them, a polymer having a butadiene skeleton, a polymer having an isoprene skeleton, and a polymer obtained by further polymerizing a (meth)acrylic acid ester and/or a monomer having a carboxyl group and/or a hydroxy group with the polymer having a butadiene skeleton or an isoprene skeleton are preferable, and a polymer obtained by further polymerizing a (meth)acrylic acid ester and/or a monomer having a carboxyl group and/or a hydroxy group with the polymer having a butadiene skeleton is more preferable. The polymer particles (a-2) may be used singly or in combinations of two or more thereof.

The average particle diameter of the polymer particles (a-2) is preferably 500 nm or less and more preferably 100 nm or less. When the average particle diameter is 500 nm or less, aqueous developing performance of the flexographic printing raw plate tends to more improve.

The toluene gel fraction of the polymer particles (a-2) is preferably 60% to 99%. When the toluene gel fraction is 60% or more, practically sufficient strength tends to be imparted to a printing plate to be obtained. When the toluene gel fraction is 99% or less, mixing properties between the polymer particles (a-2) and the thermoplastic elastomer (a-1) tend to be good.

The toluene gel fraction herein is a mass fraction (%) obtained as follows. An appropriate amount of a dispersion containing about 30% by mass of the polymer particles (a-2) is dropped on a Teflon (R) sheet followed by drying at 130°C for 30 minutes; 0.5 g of the polymer particles (a-2) is taken therefrom and immersed in 30 mL of toluene at 25°C followed by shaking for three hours using a shaking device and subsequent filtration with a 320 SUS mesh; the matter not passing through the mesh is dried at 130°C for one hour; and the mass of the dried matter is divided by 0.5 (g).

The content of the polymer particles (a-2) is preferably 10 to 70% by mass, more preferably 15 to 60% by mass, and still more preferably 20 to 50% by mass based on 100% by mass of the total amount of the photosensitive resin composition in view of developing performance at the time of producing a printing plate.

### (Manufacturing method of polymer particles (a-2))

A synthesis method of the polymer particles (a-2) is not particularly limited, and a polymer synthesized through emulsion polymerization is preferable, for example. Examples of the emulsion polymerization method of the polymer particles (a-2) include a method in which predetermined amounts of water, an emulsifier, and other additives are fed, in advance, to a reaction system having been adjusted to a temperature at which polymerization is possible, and a polymerization initiator and a monomer, an emulsifier, an adjuster, and the like are added into this reaction system by batch operation or continuous operation. In addition, predetermined amounts of a seed latex, a polymerization initiator, a monomer, and another adjuster may be added in advance to the emulsion polymerization reaction system.

The layer structure of polymer particles to be synthesized can also be changed stepwise by devising a method of adding the monomer, emulsifier, other additives, and adjuster to the reaction system. In this case, physical properties representing the structure of each layer include hydrophilicity, glass transition temperature, molecular weight, crosslinking density. The number of layers in this layer structure is not particularly limited.

Hereinafter, each component other than the already mentioned monomer will be described.

The emulsifier (surfactant) used at the time of emulsion polymerization is not particularly limited, and examples thereof include a reactive emulsifier and/or a non-reactive emulsifier. Among them, a reactive emulsifier is preferably used.

The reactive emulsifier is preferably a reactive emulsifier including a radically polymerizable double bond, a hydrophilic functional group, and a hydrophobic group in its molecular structure and having emulsifying, dispersing, and swelling functions as with common emulsifiers. Among them, a preferable reactive emulsifier (surfactant) is such that the reactive emulsifier is capable of providing a polymer particles having an average particle diameter of 5 to 500 nm when the reactive emulsifier is used in an amount of 0.1 parts by mass or more per 100 parts by mass of all monomers but the reactive emulsifier.

The hydrophilic functional group of the reactive emulsifier is not particularly limited, and examples thereof include anionic groups such as a sulfate group, a nitrate group, a phosphate group, a borate group, and a carboxy group; cationic groups such as an amino group; polyoxyalkylene chain structure or the like such as polyoxyethylene, polyoxymethylene, and polyoxypropylene; or hydroxy group. The reactive emulsifier can be classified into an anionic emulsifier, a nonionic emulsifier, a cationic emulsifier, or an amphoteric emulsifier, according to the type of the hydrophilic functional group.

The hydrophobic group of the reactive emulsifier is not particularly limited, and examples thereof include an alkyl group and a phenyl group. The radically polymerizable double bond of the reactive emulsifier is not particularly limited, and examples thereof include a vinyl group and an acryloyl group or a methacryloyl group. The radically polymerizable double bond, the hydrophilic functional group, and the hydrophobic group may each be included in the molecular structure in a combination of several types.

The commercially available surfactant can be used as the reactive emulsifier. The commercially available anionic surfactant is not particularly limited, and examples thereof include ADEKA REASOAP SE (manufactured by ADEKA Corporation), Aqualon HS, BC, and KH (manufactured by DKS Co. Ltd.), LATEMUL S (manufactured by Kao Corporation), Antox MS (manufactured by Nippon Nyukazai Co., Ltd.), ADEKA REASOAP SDX and PP (manufactured by ADEKA Corporation), Hightenol A (manufactured by DKS Co. Ltd.), ELEMINOL RS (manufactured by Sanyo Chemical Industries, Ltd.), and SPINOMAR (manufactured by Toyo Soda Kogyo Kabushiki Kaisha). The commercially available nonionic surfactant is not particularly limited, and examples thereof include Aqualon RN and Noigen N (manufactured by DKS Co. Ltd.) and ADEKA REASOAP NE (manufactured by ADEKA Corporation). These may be used singly, or two or more thereof may be used in combination.

The amount of the reactive emulsifier used is preferably 1 to 20 parts by mass per 100 parts by mass of the polymer particles (a-2) calculated from the amount of starting materials fed. When the amount of the reactive emulsifier is 1 part by mass or more, image reproducibility of a printing plate obtained tends to improve. When the amount of the reactive emulsifier is 20 parts by mass or less, wear resistance of the printing plate obtained tends to improve.

Examples of the non-reactive emulsifier include, but not particularly limited to, anionic surfactants such as fatty acid soap, rosin acid soap, a sulfonate, a sulfate, a phosphate, a polyphosphate, and an acyl sarcosinate; cationic surfactants such as a nitrilated fat or oil derivative, a fat or oil derivative, a fatty acid derivative, and an α-olefin derivative; and nonionic surfactants such as an alcohol ethoxylate, an alkylphenol ethoxylate, a propoxylate, a fatty acid alkanolamide, an alkyl polyglycoside, a polyoxyethylene sorbitan fatty acid ester, and an oxyethylene oxypropylene block copolymer. These may be used singly, or two or more thereof may be used in combination.

Examples of the above-described sulfonate include, but not particularly limited to, an alkyl sulfonate, an alkyl sulfate, an alkyl sulfosuccinate, a polyoxyethylene alkyl sulfate, sulfonated fat or oil, an alkyldiphenylether disulfonate, an α-olefin sulfonate, an alkyl glyceryl ether sulfonate, and an N-acylmethyltaurate. Examples of the non-reactive emulsifier other than those described above include, but are not particularly limited to, those described in "Kaimenkasseizai handobukku (Surfactant Handbook) (Takahashi, Namba, Koike, Kobayashi: Kougakutosho Ltd., 1972)".

The amount of the non-reactive emulsifier used is preferably less than 1 part by mass per 100 parts by mass of the polymer particles (a-2) calculated from an amount of starting material fed. When the amount of the non-reactive emulsifier used is less than 1 part by mass, a printing plate to be obtained has an appropriate water swelling ratio, and a decrease of abrasion resistance occurring when ink attaches and a decrease of image reproducibility after absorbing moisture can be thus prevented.

The polymerization initiator is not particularly limited, and examples thereof include a radical polymerization initiator. The radical polymerization initiator is not particularly limited and is, for example, radically decomposed under the presence of heat or a reducing substance to initiate addition polymerization of monomers, and both of an inorganic initiator and an organic initiator can be used.

The radical polymerization initiator is not particularly limited, and examples thereof include a water-soluble or oil-soluble peroxodisulfate, a peroxide, and an azobis compound, and specific examples thereof include potassium peroxodisulfate, sodium peroxodisulfate, ammonium peroxodisulfate, hydrogen peroxide, t-butyl hydroperoxide, benzoyl peroxide, 2,2-azobis butyronitrile, and cumene hydroperoxide. Compounds described in POLYMER HANDBOOK (3rd edition), written by J. Brandup and E.H. Immergut, published by John Willy & Sons, (1989) can also be used as the radical polymerization initiator. A so-called redox polymerization method, in which a reducing agent such as sodium acidic sulfite, ascorbic acid or a salt thereof, erythorbic acid and a salt thereof, or Rongalit is used in combination with a polymerization initiator, can also be employed. Among them, peroxodisulfate is preferable as the polymerization initiator.

The amount of the polymerization initiator used is usually 0.1% to 5.0% by mass and is preferably 0.2 to 3.0% by mass based on the total amount of monomers used for polymerization of the polymer particles (a-2). When the amount of the polymerization initiator used is 0.1% by mass or more, high stability can be obtained at the time of synthesizing the polymer particles (a-2). When the amount of the polymerization initiator used is 5.0% by mass or less, the amount of moisture absorbed by the photosensitive resin composition can be reduced so as to fall within a practically preferable range.

A known chain transfer agent can be used in the polymerization process of the polymer particles (a-2). A chain transfer agent including sulfur can be preferably used as the chain transfer agent. Examples of the chain transfer agent including sulfur include, but not particularly limited to, an alkanethiol such as t-dodecyl mercaptan and n-dodecyl mercaptan; a thioalkyl alcohol such as mercaptoethanol and mercaptopropanol; a thioalkyl carboxylic acid such as thioglycolic acid and thiopropionic acid; an alkyl thiocarboxylate acid such as octyl thioglycolate and octyl thiopropionate; and a sulfide such as dimethyl sulfide and diethyl sulfide.

Examples of the other chain transfer agents include, but not particularly limited to, terpinolene, dipentene, t-terpinene, and a hydrocarbon halide such as carbon tetrachloride. Among these chain transfer agents, alkanethiols are preferable because they have large chain transfer rates and give polymerization products having well-balanced physical properties. These chain transfer agents may be used singly, or two or more thereof may be used in combination.

These chain transfer agents are mixed to monomers and then supplied to a reaction system or independently added in a predetermined amount at a predetermined time. The amount of these chain transfer agents used is preferably 0.1% to 10% by mass based on the total amount of monomers used for polymerization of the polymer particles (a-2). The amount of 0.1% by mass or more provides good processability at the time of mixing the photosensitive resin composition, and the amount of 10% by mass or less enables the molecular weight of the polymer particles (a-2) to be practically sufficient.

A polymerization reaction suppressing agent can be used for polymerization of the polymer particles (a-2) as needed. The polymerization reaction suppressing agent is a compound added to an emulsion polymerization system to decrease a radical polymerization rate. More specifically, the polymerization reaction suppressing agent includes a polymerization rate retardant, a polymerization inhibitor, a chain transfer agent with low radical reinitiation reactivity, and a monomer with low radical reinitiation reactivity. The polymerization reaction suppressing agent is usually used for adjusting a polymerization reaction rate and adjusting physical properties of a latex. These polymerization reaction suppressing agents are added to a reaction system by batch operation or continuous operation. When the polymerization reaction suppressing agent is used, strength of a latex coating improves, and wear resistance of the plate thus improves. While details of the reaction mechanism is unclear, the polymerization reaction suppressing agent is thought to closely relate to steric structure of a polymer, and it is assumed that the polymerization reaction suppressing agent thus has an effect of adjusting physical properties of a latex coating.

Examples of the polymerization reaction suppressing agent include, but not particularly limited to, quinones such as o-, m-, or p-benzoquinone; nitro compounds such as nitrobenzene, o-, m-, or p-dinitrobenzene; amines such as diphenylamine; catechol derivatives such as tertiary butyl catechol; 1,1-di-substituted vinyl compounds such as 1,1-diphenylethylene or α-methylstyrene and 2,4-diphenyl-4-methyl-1-pentene; and 1,2-di-substituted vinyl compounds such as 2,4-diphenyl-4-methyl-2-pentene and cyclohexene. Besides, compounds described as a polymerization inhibitor or polymerization suppressing agent in "POLYMER HANDBOOK 3rd Ed. (J. Brandup, E.H. Immergut: John Wiley & Sons, 1989)," and "Kaitei koubunshigousei no kagaku (Chemistry of polymer synthesis revised edition) (Otsu: Kagaku-Dojin Publishing Company, INC, 1979)" are exemplified.

Among them, 2,4-diphenyl-4-methyl-1-pentene (α-methylstyrene dimer) is especially preferable in view of reactivity. These polymerization reaction suppressing agents may be used singly, or two or more thereof may be used in combination.

The amount of these polymerization reaction suppressing agents used is preferably 10% by mass or less based on the total amount of monomers used for polymerization of the polymer particles (a-2). By setting the amount to 10% by mass or less, a practically sufficient polymerization rate tends to be obtained.

Various polymerization adjusters such as a pH adjuster and a chelating agent can be added at the time of synthesizing the polymer particles (a-2) as needed.

The pH adjuster is not particularly limited, and examples thereof include sodium hydroxide, potassium hydroxide, ammonium hydroxide, sodium hydrogen carbonate, sodium carbonate, and disodium hydrogen phosphate.

The chelating agent is not particularly limited, and examples thereof include sodium ethylenediaminetetraacetate.

Furthermore, as other additives, various additives may be added, including a viscosity reducing agent such as an alkali-sensitive latex and hexametaphosphoric acid; a water-soluble polymer such as a polyvinyl alcohol and carboxymethyl cellulose; a thickening agent; various antioxidants; an ultraviolet absorber; an antiseptic agent; a bactericidal agent; a defoaming agent; a dispersant such as sodium polyacrylate; a water resistant agent; a metal oxide such as zinc oxide; a crosslinking agent such as an isocyanate-based compound and an epoxy compound; a lubricant; and a water retaining agent.

A method for adding these additives is not particularly limited, and these additives can be added during synthesis or after synthesis of the polymer particles (a-2).

The polymerization temperature in the case where the polymer particles (a-2) is synthesized through emulsion polymerization is usually 60 to 120°C. Polymerization may be carried out by the above-described redox polymerization method or the like at a lower temperature. Furthermore, a metal catalyst such as divalent iron ion, trivalent iron ion, and copper ion may be allowed to coexist as a redox catalyst.

### 1.2.3. Photopolymerizable monomer (a-3)

Examples of the photopolymerizable monomer (a-3) include, but not particularly limited to, esters of acids such as acrylic acid, methacrylic acid, fumaric acid, and maleic acid; derivatives of acrylamides and methacrylamides; allyl esters, styrene, and derivatives thereof; and N-substituted maleimide compounds.

Examples of the photopolymerizable monomer (a-3) include, but not particularly limited to, diacrylates and dimethacrylates of alkanediols such as 1,6-hexanediol and 1,9-nonanediol; or diacrylates and dimethacrylates of ethylene glycol, diethylene glycol, propylene glycol, dipropylene glycol, polyethylene glycol, butylene glycol, and dicyclopentadienyl; trimethylolpropane tri(meth)acrylate, dimethyloltricyclodecane di(meth)acrylate, isobornyl (meth)acrylate, phenoxypolyethyleneglycol (meth)acrylate, pentaerythorit tetra(meth)acrylate, N,N'-hexamethylenebisacrylamide and N,N'-hexamethylenebismethacrylamide, styrene, vinyltoluene, divinylbenzene, diacrylphthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenylpropyl) fumarate, dilauryl fumarate, dibehenyl fumarate, and N-lauryl maleimide. These may be used singly, or two or more thereof may be used in combination.

A di(meth)acrylate monomer having two (meth)acrylate groups in one molecule is preferable as the photopolymerizable monomer (a-3) in view of higher chipping resistance at a convex part of a printing plate. The content of such a di(meth)acrylate monomer is preferably 2.0% by mass or more, more preferably 2.0 to 20% by mass, and still more preferably 5.0 to 16% by mass based on the total amount of the photosensitive resin composition.

The content of the photopolymerizable monomer (a-3) is preferably 1 to 25% by mass, more preferably 5 to 20% by mass, and still more preferably 8 to 15% by mass based on 100% by mass of the total amount of the photosensitive resin composition in view of achieving bright printing.

### 1.2.4. Photopolymerization initiator (a-4)

The photopolymerization initiator (a-4) is a compound absorbing energy of light and generating a radical. Various known initiators can be used therefor, and various organic carbonyl compounds, especially aromatic carbonyl compounds are preferably used.

Examples of the photopolymerization initiator (a-4) include, but not particularly limited to, benzophenone, 4,4-bis(diethylamino)benzophenone, t-butyl anthraquinone, 2-ethyl anthraquinone, thioxanthones such as 2,4-diethylthioxanthone, isopropylthioxanthone, and 2,4-dichlorothioxanthone; acetophenones such as diethoxyacetophenone, 2,2-dimethoxy-phenylacetophenone, 2-hydroxy-2-methyl-1-phenylpropane-1-on, benzyl dimethyl ketal, 1-hydroxycyclohexyl-phenyl ketone, 2-methyl-2-morpholino(4-thiomethylphenyl)propane-1-on, and 2-benzyl-2-dimethylamino-1-(4-morpholinophenyl)-butanone; benzoin ethers such as benzoin methyl ether, benzoin ethyl ether, benzoin isopropyl ether, and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; methyl benzoylformate; and 1,7-bisacridinylheptane; 9-phenylacridine; and 2,6-di-t-butyl-p-cresol. These may be used singly, or two or more thereof may be used in combination.

The content of the photopolymerization initiator (a-4) is preferably 0.1 to 10.0% by mass, more preferably 1.0 to 8.0% by mass, and still more preferably 1.5 to 5.0% by mass based on 100% by mass of the total amount of the photosensitive resin composition in view of improving plate formability during plate making and achieving bright printing.

A cleavable photopolymerization initiator and a hydrogen-drawing type photopolymerization initiator may be used in combination as the photopolymerization initiator (a-4). The amount of the hydrogen-drawing type photopolymerization initiator in the photosensitive resin composition is preferably 1.0% by mass or less and more preferably 0.5% by mass because image reproducibility of a printing plate and abrasion resistance are high.

### 1.2.5. Liquid diene (a-5)

The photosensitive resin composition layer may contain liquid diene (a-5). The liquid diene is a liquid compound having a carbon-carbon double bond. The term "liquid" of the "liquid diene" used herein means a form having the property of being easily flow-deformable and capable of being solidified into a deformed shape by cooling, and corresponds to an elastomer having the following property: when external force is applied, deformation occurs instantly depending on the external force, and when the external force is removed, the original shape is recovered in a short time.

The liquid diene(a-5) is not particularly limited, and examples thereof include liquid polybutadiene, liquid polyisoprene, a modified product of liquid polybutadiene, a modified product of liquid polyisoprene, a liquid acrylonitrile-butadiene copolymer, and a liquid styrene-butadiene copolymer. The liquid diene is defined as a copolymer having 50% by mass or more of a diene component.

Among them, liquid polybutadiene is preferable as the liquid diene (a-5) in view of mechanical properties of the flexographic printing raw plate of the first embodiment and a flexographic printing raw plate using the same.

The number average molecular weight of the liquid diene (a-5) is not particularly limited as long as it is liquid at 20°C. The number average molecular weight is preferably 500 or more and 60000 or less, more preferably 500 or more and 50000 or less, and still more preferably 800 or more and 50000 or less in view of wear resistance and handleability of a flexographic printing plate obtained by using the flexographic printing raw plate of the first embodiment.

The content of the liquid diene (a-5) in the photosensitive resin composition layer is preferably 10 to 40% by mass, more preferably 15 to 40% by mass, and still more preferably 20 to 40% by mass based on 100% by mass of the total amount of the photosensitive resin composition layer (b) in view of wear resistance of the flexographic printing raw plate of the first embodiment and a flexographic printing plate using the same.

### 1.2.6. Silicone compound (a-6)

Examples of the silicone compound (a-6) include silicone oil, a silane coupling agent, a silane compound, silicone rubber, and silicone resin. Among them, silicone oil is preferable because its component easily migrates to surface to highly exhibit the effect of decreasing surface energy.

The silicone compound (a-6) is not particularly limited, and examples thereof include a compound having a polyalkylsiloxane such as polydimethylsiloxane or polydiethylsiloxane in its main chain. The silicone compound (a-6) may be a compound having polysiloxane structure at a part of its molecular. The silicone compound (a-6) may be a compound in which a certain organic group is introduced into polysiloxane structure. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both of a side chain and a terminal of polysiloxane, and the like can be used.

The organic group to be introduced into polysiloxane structure is not particularly limited, and examples thereof include an amino group, a carboxy group, a carbinol group, an aryl group, an alkyl group, an alkoxycarbonyl group, an alkoxy group, a linear or branched alkyl group substituted with at least one aryl group, and a polyoxyalkylene group (hereinafter also referred to as a polyether group).

Among them, silicone oil having polysiloxane as a main skeleton and having one or more groups selected from the group consisting of an amino group, a polyether group, and a carbinol group at at least one end is more preferable as the silicone compound (a-6). When such a silicone compound (a-6) is used, transparency of the photosensitive resin composition layer tends to more improve. A commercially available product of such a silicone compound is not particularly limited, and examples thereof include KF-6000 manufactured by Shin-Etsu Chemical Co., Ltd.

The content of the silicone compound (a-6) is preferably 0.1 to 5.0% by mass, more preferably 0.5 to 3.0% by mass, and still more preferably 0.5 to 2.0% by mass based on the total amount of the photosensitive resin composition layer.

### 1.3. Intermediate layer

The flexographic printing raw plate of the first embodiment has an intermediate layer between the photosensitive resin composition layer and the infrared ablation layer. At the time when an unexposed part of the photosensitive resin composition layer is washed out after completion of the exposure, this intermediate layer is simultaneously removed.

The intermediate layer has a function of preventing substance diffusion between the photosensitive resin composition layer and the infrared ablation layer (hereinafter, also referred to as a "diffusion blocking property"). Increase in the tackiness of the infrared ablation layer can be suppressed by blocking diffusion of a low-molecular-weight component from the photosensitive resin composition layer to the infrared ablation layer. By suppressing increase in the tackiness of the infrared ablation layer, it is possible to prevent reattachment of development scums of the infrared ablation layer to the plate during a development step.

The intermediate layer preferably has a function of blocking diffusion of oxygen in the atmosphere to the photosensitive resin composition layer (hereinafter, also referred to as an "oxygen blocking property"). A stable flexographic printing plate with less size unevenness in the relief image can thereby be provided.

When the photosensitive resin composition layer is cured by irradiation with ultraviolet light, the curing proceeds by radical polymerization. If oxygen coexists upon polymerization, polymerization reaction is suppressed through the reaction of a radical product compound with the oxygen. Suppressed polymerization reaction obscures an interface between an unexposed part to be removed in a development step and an exposed part on which a pattern is to be formed. The size of a relief image might therefore become uneven among even flexographic printing raw plates on which the same design is drawn.

By contrast, the intermediate layer blocks diffusion of oxygen in the atmosphere to the photosensitive resin composition layer and thereby decreases the amount of oxygen coexisting at the time of ultraviolet curing. As a result, the polymerization reaction becomes less likely to be suppressed, and the interface between an unexposed part to be removed in a development step and an exposed part on which a pattern is to be formed becomes clear. The size of a relief image to be formed is thereby stabilized.

The diffusion blocking property and oxygen blocking property (hereinafter, also collectively referred to as "blocking properties") of the intermediate layer are preferably stable regardless of a storage environment. A factor that reduces these blocking properties includes moisture absorption of the intermediate layer. The intermediate layer absorbs moisture, thereby increasing plasticity more than necessary, resulting in reduction in blocking properties.

If the diffusion blocking property is reduced, the tackiness of the infrared ablation layer is increased over time so that development scums of the infrared ablation layer might reattach to the plate at the time of development. If the oxygen blocking property is reduced, the amount of oxygen coexisting is increased during ultraviolet curing of a relief image so that a relief image might be decreased in size against the intent.

The intermediate layer is preferably soft enough to exert a function of sufficiently securing adhesion between the photosensitive resin composition layer and the infrared ablation layer and not to impair the flexibility of the flexographic printing raw plate.

A cover film on the infrared ablation layer can be peeled without damaging the infrared ablation layer in a manufacturing process of a flexographic printing plate, by sufficiently securing adhesion between the photosensitive resin composition layer and the infrared ablation layer. In a development step as well, the infrared ablation layer can be rapidly developed because the infrared ablation layer and the intermediate layer adhere to each other and can thereby be simultaneously removed.

The intermediate layer also has a function of protecting the infrared ablation layer. In a conventional manufacturing process of a flexographic printing plate, an infrared ablation layer might physically have a missing part, which becomes a pinhole, by contact with a roll upon film feed or by rubbing with a protective film resulting from tight winding during film roll transport. In the case of stacking a photosensitive resin composition layer and an infrared ablation layer by a method of coating the infrared ablation layer with the photosensitive resin composition layer while extrusion molding is performed, pinholes might occur due to friction resulting from flow of a heat-melted photosensitive resin composition on the infrared ablation layer.

In order to prevent such pinholes of the infrared ablation layer, the intermediate layer that constitutes the flexographic printing raw plate of the first embodiment preferably has physical strength and heat resistance (hereinafter, also collectively referred to as "PH resistance").

If the infrared ablation layer has pinholes, the photosensitive resin composition layer in contact with the pinholes is exposed in relief exposure. Therefore, the formation of an unintended image occurs, causing a problem of a large relief image against the intent and poor reproducibility of a flexographic printing plate.

In the flexographic printing raw plate of the first embodiment, in a tensile stress-strain curve diagram measured by molding the intermediate layer into dumbbell shape No. 8 with a thickness of 100 µm in accordance with JIS K 6251 (2017), an elongation at a breaking point is 5% or more and 200% or less, an elongation at a point where the stress is maximized is 3% or more and 200% or less, and a maximum value of the stress is 1.0 MPa or more and 15 MPa or less. A flexographic printing raw plate that enables the infrared ablation layer and the intermediate layer to be rapidly removed at the time of development and has good PH resistance without damaging the infrared ablation layer even after plate curving can thereby be provided.

In the present embodiment, the "dumbbell shape No. 8 with a thickness of 100 µm" means dumbbell shape No. 8 produced in accordance with JIS K 6251 (2017) except that the thickness is 100 µm.

### 1.3.1. Description of tensile physical property

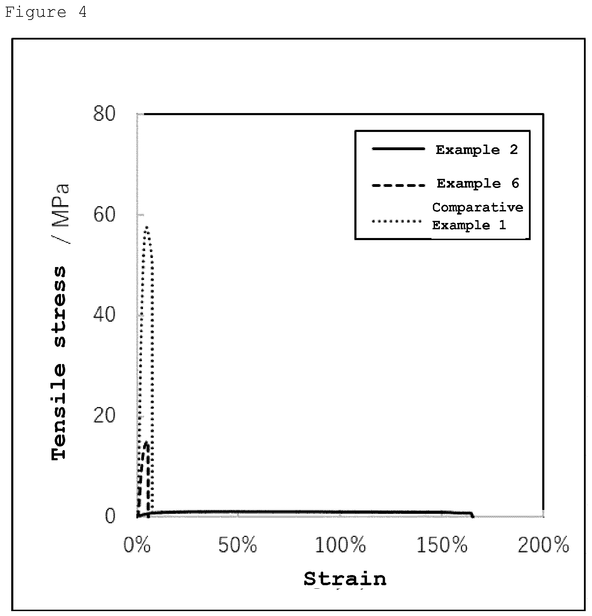

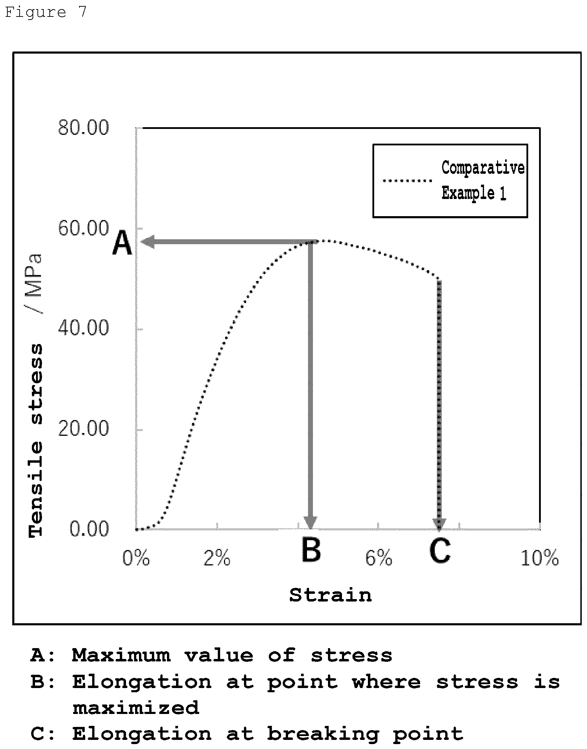

The tensile stress-strain curve diagram of the present embodiment is a curve diagram in which a strain (%) is plotted on the abscissa against a tensile stress (Pa) on the ordinate, as shown in Figures 4 to 7. A detailed measurement method is described in the section of Examples.

A smaller elongation at a breaking point of the intermediate layer of the present embodiment is more preferable in view of developing performance. The intermediate layer is thereby fractured in a brittle manner when a stress by a brush or spray is applied to the intermediate layer in a development step. As a result, the intermediate layer can be rapidly removed together with the infrared ablation layer. From such viewpoints, the elongation at a breaking point is 200% or less, more preferably 150% or less, further preferably 100% or less, and especially preferably 50% or less.

On the other hand, a larger elongation at a breaking point of the intermediate layer of the present embodiment is more preferable in view of inhibiting PH at the time of plate transport or handling. From such viewpoints, the elongation at a breaking point is 5% or more, preferably 7% or more, and more preferably 10% or more.

The intermediate layer up to a point where the stress is maximized corresponds to an elastic region and is therefore reversibly deformable. The intermediate layer that can be reversibly deformed can inhibit damage on the infrared ablation layer derived from a strain between the intermediate layer and the infrared ablation layer even if the raw plate is curved when wound on a drum of a laser ablation device, for example. In the case of winding a 3 mm thick raw plate on a usually commercially available laser ablation device of the smallest size (CDI Spark 1712), the surface of the raw plate is stretched by about 2%. From such viewpoints, a larger elongation of the intermediate layer of the present embodiment up to a point where the stress is maximized is more preferable. Specifically, the elongation at this point is 3% or more, more preferably 5% or more, further preferably 7% or more, and especially preferably 10% or more.

On the other hand, a smaller elongation at a point where the stress is maximized is more preferable in view of developing performance. The intermediate layer is thereby fractured in a brittle manner when a stress by a brush or spray is applied to the intermediate layer in a development step. As a result, the intermediate layer can be rapidly removed together with the infrared ablation layer. From such viewpoints, the elongation at a point where the stress is maximized is 200% or less, more preferably 150% or less, further preferably 100% or less, and especially preferably 50% or less.

A smaller maximum value of the stress of the intermediate layer is more preferable in view of developing performance. The infrared ablation layer and the intermediate layer can thereby be rapidly removed under a stress by a brush, spray, or the like at the time of development. From such viewpoints, the maximum value of the stress is 15 MPa or less, preferably 13 MPa or more, and more preferably 10 MPa or more.

On the other hand, a larger maximum value of the stress of the intermediate layer is more preferable in view of inhibiting PH at the time of plate transport or handling. From such viewpoints, the maximum value of the stress is 1.0 MPa or more, preferably 2.0 MPa or more, more preferably 3.0 MPa or more, and further preferably 4.0 MPa or more.

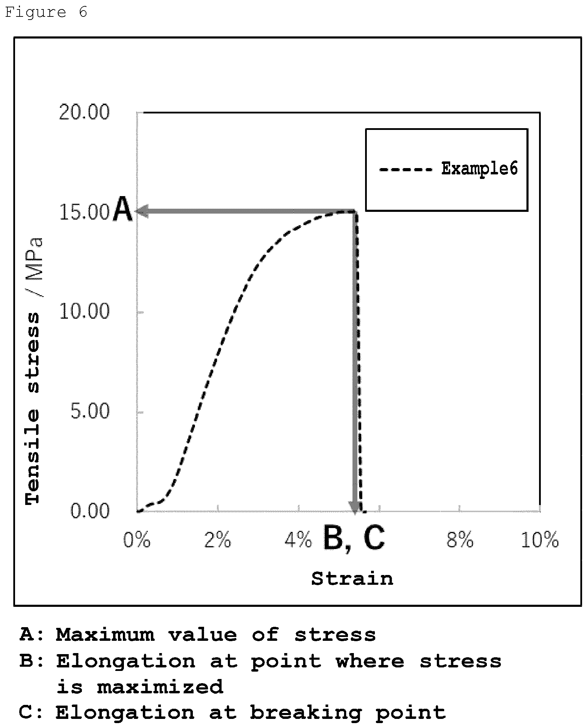

The point where the stress is maximized for the intermediate layer may be the same as the breaking point of the intermediate layer. A specific example thereof corresponds to Example 6 (Figure 6), etc.

### 1.3.2. Description of water contact angle

The intermediate layer of the first embodiment preferably has a water contact angle of 60° or more 3 minutes after dropwise addition on the surface serving as an interface with the infrared ablation layer. The intermediate layer thereby has low moisture absorbency and can maintain its high blocking properties even if stored under high humidity. From such viewpoints, the water contact angle 3 minutes after dropwise addition is more preferably 65° or more, and further preferably 70° or more.

The intermediate layer preferably has a water contact angle of 90° or less 3 minutes after dropwise addition on the surface serving as an interface with the infrared ablation layer. The infrared ablation layer and the intermediate layer can thereby be rapidly removed at the time of development. From such viewpoints, the water contact angle 3 minutes after dropwise addition is more preferably 85° or less, and further preferably 80° or less.

It is important for the contact angle of the intermediate layer to adopt a value 3 minutes after dropwise addition. This value is capable of serving as an index for controlling hydrophilicity not only of the surface of the intermediate layer but including the inside of the intermediate layer. A detailed measurement method is described in the section of Examples.

The intermediate layer of the first embodiment preferably contains an emulsion compound (A) having a glass transition temperature (Tg) of 30°C or higher. A flexographic printing raw plate that can adjust the tensile physical properties and the water contact angle to predetermined numeric ranges, does not reduce the blocking properties of the intermediate layer even if stored under high humidity, and enables the infrared ablation layer and the intermediate layer to be rapidly removed at the time of development can thereby be provided.

Although the details thereof are not clear, the present inventors surmise the following. First, the moisture resistance of the flexographic printing raw plate can be enhanced by including the first feature "emulsion compound". A micelle of the emulsion compound collapses during the course of thin film formation through coating and drying processes so that a hydrophobic moiety appears on the surface. As a result, a hydrophobic intermediate layer that does not reduce blocking properties even if stored under high humidity can be formed.

Next, the second feature "Tg of 30°C or higher" does not reduce blocking properties even if the intermediate layer is stored under high humidity, and enables the infrared ablation layer and the intermediate layer to be rapidly removed at the time of development. The emulsion compound (A) having Tg of 30°C or higher is in a glass state in which micro-Brownian motion is frozen at 0 to 30°C, which is a usual storage temperature of the flexographic printing raw plate. When a water molecule in the atmosphere enters into the flexographic printing raw plate, water diffuses and enters with the micro-Brownian motion of a constituent polymer as driving force. The glass state, however, can prevent the entry of water. This prevents the plasticity of the intermediate layer from being increased more than necessary by moisture absorption, and can maintain its blocking properties.

The emulsion compound (A) having Tg of 30°C or higher is in a glass state in which micro-Brownian motion is frozen at 30°C, which is a usual temperature of a development step of the flexographic printing raw plate. When the emulsion compound is in a glass state, the intermediate layer is fractured in a brittle manner, not in a ductile manner, by the application of physical force by a brush and/or spraying of a developer at the time of development. The brittle fracture compared with ductile fracture is a phenomenon in which deformation leading to fracture is small and causes rapid fracture. This enables the intermediate layer to be rapidly developed. Furthermore, the infrared ablation layer stacked on the intermediate layer can be simultaneously removed.

The intermediate layer may optionally include, in addition to the emulsion compound (A), an emulsion compound (B) having a glass transition temperature (Tg) of 10°C or lower, a layered inorganic compound (C), a crosslinking agent (D), a binder polymer, a filler, silicone oil, a surfactant, a coating aid, or the like.

A larger thickness of the intermediate layer in the flexographic printing raw plate of the first embodiment is more preferable in view of inhibiting mass transfer between layers. A smaller thickness is more preferable in view of developing performance. Taking the balance among them into consideration, the thickness of the intermediate layer is preferably more than 2.0 µm and 30 µm or less, more preferably more than 2.0 µm and 15 µm or less, and further preferably 2.4 µm or more and 10 µm or less.

It is preferable that the intermediate layer can be cleaned with the same developer as that for the infrared ablation layer and/or the photosensitive resin composition layer in view of a convenient manufacturing process of a flexographic printing plate. High cleanability of the intermediate layer can shorten the time required for a cleaning step and improves workability, and the photosensitive resin composition layer positioned below the intermediate layer can be easily developed.

Hereinafter, each component contained in the intermediate layer will be described in detail.

### 1.3.3. Emulsion compound (A)

The intermediate layer in the flexographic printing raw plate of the first embodiment includes an emulsion compound (A) having a glass transition temperature (Tg) of 30°C or higher. The "emulsion compound" refers to a polymer that has a hydrophobic moiety and a hydrophilic moiety in a molecule and is dispersed in a micelle form in an aqueous solution.

The hydrophobic moiety is not particularly limited, and examples thereof include saturated alkyl, unsaturated alkyl, polyether, polyester, poly(meth)acryl, polyurethane, polycarbonate, polybutadiene, polystyrene, polyacrylonitrile, polychloroprene, polypropylene, polyisoprene, polyvinylidene chloride, polyvinyl chloride, polyamide, and copolymers of two or more polymers selected therefrom.

The hydrophilic moiety is not particularly limited, and examples thereof include an amino group, an imino group, a tertiary amine group, a quaternary ammonium base, a hydrazide group, a carboxyl group, a sulfonyl group, a sulfuric acid ester group, a phosphoric acid ester group, an ether group, a hydroxy group, an amide group, and atomic groups including them. These hydrophilic moieties may be used singly, or two or more thereof may be used in combination.

Particularly, in the case of development with an alkali developer, it is preferable to include at least one of a carboxyl group and a sulfonyl group.

Specific examples of the emulsion compound include, but are not particularly limited to, polyester emulsions, polyurethane emulsions, polyacrylamide emulsions, water-dispersible latex polymers such as polybutadiene latexes, natural rubber latexes, styrene-butadiene copolymer latexes, acrylonitrile-butadiene copolymer latexes, polyvinylidene chloride latexes, polychloroprene latexes, polyisoprene latexes, polyurethane latexes, methyl methacrylate-butadiene copolymer latexes, vinylpyridine polymer latexes, butyl polymer latexes, Thiokol polymer latexes, and acrylate polymer latexes, and polymers obtained by copolymerizing other components such as acrylic acid or methacrylic acid with these polymers.

Among them, the emulsion compound (A) preferably includes an aromatic unit in view of facilitating molecule design that elevates Tg. A polyester emulsion is especially preferable from the viewpoint that in the case of development with an alkali developer, rapid development can be achieved. The inventors surmise that this is because rapid removal can be achieved at the time of development by the hydrolysis of an ester bond with an alkali.

Although the emulsion compound (A) may be used singly, it is preferable to use two or more thereof in combination.

The polyester emulsion is a polymerization product of a polyvalent carboxylic acid component and a glycol component. The polyvalent carboxylic acid component consists of one or more compounds selected from divalent or more polyvalent carboxylic acid and an ester-forming derivative of the polyvalent carboxylic acid. The ester-forming derivative of the polyvalent carboxylic acid is a derivative such as an anhydride, ester, acid chloride, or halide of the polyvalent carboxylic acid and is a compound that reacts with the glycol component described later to form ester. The polyvalent carboxylic acid has two or more carboxyl groups per molecule.

Examples of the polyvalent carboxylic acid component include aliphatic dicarboxylic acid such as succinic acid, adipic acid, sebacic acid, and dodecanedioic acid; and aromatic polyvalent carboxylic acid such as terephthalic acid, isophthalic acid, 2,6-naphthalenedicarboxylic acid, 5-sulfoisophthalic acid, 2-sulfoisophthalic acid, 4-sulfoisophthalic acid, sulfoterephthalic acid, 4-sulfonaphthalene-2,6-dicarboxylic acid, hemimellitic acid, trimellitic acid, trimesic acid, mellophanic acid, pyromellitic acid, benzenepentacarboxylic acid, mellitic acid, cyclopropane-1,2,3-tricarboxylic acid, cyclopentane-1,2,3,4-tetracarboxylic acid, and ethanetetracarboxylic acid.

Among them, the emulsion compound preferably includes an aromatic unit in view of facilitating molecular design that elevates Tg, as mentioned above. In short, it is preferable to include at least one or more aromatic polyvalent carboxylic acid as a copolymer component of the polyester emulsion.

In the case of enhancing developing performance against an alkali developer, it is further preferable to include trivalent or more aromatic polyvalent carboxylic acid and/or aromatic polyvalent carboxylic acid having a metal sulfonate group, and a co-polyester emulsion that includes an aromatic polyvalent carboxylic acid component as a copolymer component and has a carboxyl group and/or a sulfonate group is more preferable.

The polyhydric alcohol is not particularly limited, and examples thereof include ethylene glycol, polyethylene glycol, propylene glycol, polypropylene glycol, polytetramethylene glycol, polyhexamethylene glycol, polyheptamethylene glycol, polydecamethylene glycol, glycerin, trimethylolpropane, pentaerythritol, bisphenol A, bisphenol F, hydrogenated bisphenol A, hydrogenated bisphenol F, hydroquinone, naphthohydroquinone, anthrahydroquinone, 1,4-cyclohexanediol, tricyclodecanediol, tricyclodecane dimethanol, pentacyclopentadecanediol, and pentacyclopentadecane dimethanol. These may be used singly, or two or more thereof may be used in combination.

The ratio between the polyvalent carboxylic acid component and the polyhydric alcohol component is preferably adjusted such that the molar ratio between the total number of a carboxyl group and its ester-forming derivative group contained in the polyvalent carboxylic acid component and the total number of a hydroxyl group and its ester-forming derivative group contained in the polyhydric alcohol component falls within the range of 1:1.1 to 2.5. In this case, trivalent or more polyvalent carboxylic acid or the like is regarded as dicarboxylic acid for calculation of the ratio.

The intermediate layer of the first embodiment preferably contains an emulsion compound (A) having Tg of 30°C or higher. A flexographic printing raw plate excellent in developing performance and blocking properties can thereby be provided for the reasons mentioned above. Higher Tg of the emulsion compound is preferable in view of expanding the application ranges of a storage temperature and a use temperature. On the other hand, it is preferable that the emulsion compound be not in a glass state in coating and drying processes in manufacturing the intermediate layer, in view of film formability.

From such viewpoints, the Tg of the emulsion compound (A) is preferably 30°C or higher, more preferably 35°C or higher and 120°C or lower, further preferably 40°C or higher and 100°C or lower, and especially preferably 45°C or higher and 70°C or lower.

The glass transition temperature Tg refers to a value measured by DSC in accordance with JIS K 7121 (1987) and specifically refers to a glass transition temperature (Tg) obtained by placing the emulsion compound in a differential scanning calorimeter, elevating the temperature to (Tg + 50°C) at a temperature elevation rate of 10°C/min, then keeping the temperature for 10 minutes, then rapidly cooling the compound, and reading a value from the obtained differential thermal curve.

A commercially available product can be used as the emulsion compound (A). For a commercially available product of the emulsion compound, a catalog data of the commercially available product is preferentially adopted as Tg.

The acid value of the emulsion compound (A) contained in the intermediate layer is preferably 5 mg KOH/g or more, more preferably 10 mg KOH/g or more, further preferably 20 mg KOH/g or more, and especially preferably 30 mg KOH/g or more in view of developing performance.

On the other hand, the acid value is preferably 140 mg KOH/g or less, more preferably 120 mg KOH/g or less, further preferably 100 mg KOH/g or less, and especially preferably 80 mg KOH/g or less in view of moisture absorption resistance.

A larger number average molecular weight (Mn) of the emulsion compound (A) having Tg of 30°C or higher contained in the intermediate layer is preferable in view of enhancing strength and preventing PH, and smaller Mn is preferable from the viewpoint that rapid removal can be achieved by giving priority to brittle fracture at the time of development. The inventors surmise that this is because, as disclosed in the literature "Polymer, 37, 1177 (1996)", for example, a smaller number average molecular weight facilitates forming craze which is a precursor phenomenon of brittle fracture.

Taking the balance among them into consideration, the number average molecular weight Mn of the emulsion compound (A) is preferably 1,000 or more and 100,000 or less, more preferably 1,500 or more and 75,000 or less, further preferably 2,000 or more and 50,000 or less, and especially preferably 2,500 or more and 30,000 or less.

The number average molecular weight Mn is measured by gel permeation chromatography (GPC) and can be determined from a molecular weight at the peak of a chromatogram using a calibration curve (prepared using the peak molecular weight of standard polystyrene) determined from the measurement of commercially available standard polystyrene. Detailed measurement conditions are as described in the section of Examples described later. For a commercially available product of the emulsion compound, a catalog data of the commercially available product is preferentially adopted as a number average molecular weight.

A larger content of the emulsion compound (A) is preferable in view of developing performance, plate reproducibility, and an attachment property of development scums, and a smaller content is preferable in view of improving the elongation of the intermediate layer and inhibiting PH at the time of handling. From such viewpoints, the content of the emulsion compound (A) is preferably 10% by mass or more, further preferably 25% by mass or more, and especially preferably 40% by mass or more based on the total amount of the intermediate layer. The upper limit of the content of the emulsion compound (A) is not particularly limited and is preferably 99% by mass or less, more preferably 98% by mass or less, further preferably 95% by mass or less, and especially preferably 80% by mass or less based on the total amount of the intermediate layer. When the content of the emulsion compound (A) is 10% by mass or more, developing performance and plate reproducibility tend to more improve, and an attachment property of development scums tends to be more reduced.

The particle diameter of the emulsion compound (A) can be selected within an arbitrary range. A smaller particle diameter attains rapid development, and a larger particle diameter enhances dispersion stability in a coating liquid. Taking the balance among them into consideration, the particle diameter of the emulsion compound (A) is preferably 5 nm or more and 1000 nm or less, and more preferably 10 nm or more and 500 nm or less.

In addition to water, a small amount of an alkaline compound may be added in dispersing the emulsion compound (A) in water. This tends to improve the dispersibility of the emulsion compound (A) and improve plate reproducibility.

Examples of the alkali compound include, but are not limited to, ammonia, monoethanolamine, diethanolamine, triethanolamine, monoisopropanolamine, diisopropanolamine, triisopropanolamine, monoethylamine, diethylamine, triethylamine, butylamine, pentylamine, propylamine, isopropylamine, benzylamine, sodium hydroxide, potassium hydroxide, calcium hydroxide, sodium carbonate, sodium percarbonate, sodium hydrogen carbonate, potassium carbonate, and calcium carbonate. Ammonia, diethanolamine, triethanolamine, sodium hydroxide, potassium hydroxide, or sodium carbonate is preferable in view of safety and basicity.

The amount of the compound added is preferably 10 parts by mass or less, more preferably 5 parts by mass or less, and especially preferably 2 parts by mass or less based on 100 parts by mass of the emulsion compound (A).

### 1.3.4. Emulsion compound (B)

The intermediate layer of the first embodiment preferably includes, in addition to the emulsion compound (A), an emulsion compound (B) having Tg of 10°C or lower in order that the intermediate layer is soft enough not to impair the flexibility of the flexographic printing raw plate.

When such Tg of the emulsion compound (B) falls below a usual use temperature 20°C of the flexographic printing raw plate, the present inventors surmise that sufficient softness can be secured because of micro-Brownian motion of the emulsion compound (B). From such viewpoints, the Tg of the emulsion compound (B) is preferably 10°C or lower, and further preferably 0°C or lower.

The emulsion compound (B) is not particularly limited as long as its Tg is 10°C or lower, and specific examples of the type thereof include the same as those of the emulsion compound (A). Specific examples thereof include polyester emulsions, polyurethane emulsions, polyacrylamide emulsions, water-dispersible latex polymers such as polybutadiene latexes, natural rubber latexes, styrene-butadiene copolymer latexes, acrylonitrile-butadiene copolymer latexes, polyvinylidene chloride latexes, polychloroprene latexes, polyisoprene latexes, polyurethane latexes, methyl methacrylate-butadiene copolymer latexes, vinylpyridine polymer latexes, butyl polymer latexes, Thiokol polymer latexes, and acrylate polymer latexes, and polymers obtained by copolymerizing other components such as acrylic acid or methacrylic acid with these polymers.

Among them, a polyurethane emulsion, a polybutadiene latex, a styrene-butadiene copolymer latex, or an acrylonitrile-butadiene copolymer latex is especially preferable in view of softness and compatibility with a polyester emulsion. Such an emulsion selected can enhance the elongation of the intermediate layer and facilitates adjusting tensile physical properties to a predetermined numeric range. Such an emulsion may include a small amount of an arbitrary component, for example, (meth)acrylic acid or an antioxidant, as a copolymer component or an additive.

The content of the emulsion compound (B) is preferably 5% by mass or more and 90% by mass or less, more preferably 10% by mass or more and 70% by mass or less, and especially preferably 15% by mass or more and 40% by mass or less based on the total amount of the intermediate layer. When the content of the emulsion compound (B) is 5% by mass or more, the intermediate layer tends to be soft enough not to impair the flexibility of the flexographic printing raw plate. When the content of the emulsion compound (B) is 90% by mass or less, developing performance tends to more improve.

The particle diameter of the emulsion compound (B) can be selected within an arbitrary range. A smaller particle diameter attains rapid development, and a larger particle diameter enhances dispersion stability in a coating liquid. Taking the balance among them into consideration, the particle diameter of the emulsion compound (B) is preferably 5 nm or more and 1000 nm or less, and more preferably 10 nm or more and 500 nm or less.

The relative weight ratio between the emulsion compound (A) mentioned above and the emulsion compound (B), (A)/(B), is preferably 1.0 or more and 2.3 or less, and more preferably 1.1 or more and 2.0 or less. When the relative weight ratio between the emulsion compound (A) and the emulsion compound (B), (A)/(B), is 1.0 or more, the intermediate layer tends to be soft enough not to impair the flexibility of the flexographic printing raw plate, and thereby have good PH resistance. When the relative weight ratio between the emulsion compound (A) and the emulsion compound (B), (A)/(B), is 2.3 or less, developing performance tends to more improve because plastic fracture occurs preferentially at the time of development by keeping a breaking-point elongation low.

### 1.3.5. Layered inorganic compound (C)

In the first embodiment, the "layered inorganic compound (C)" refers to an inorganic compound in which unit crystal layers are stacked to form layered particle. A compound which swells and/or is cleaved in water is preferable as the layered inorganic compound (C), and examples thereof include a clay compound having water swellability. Examples of the layered inorganic compound (C) include a compound containing aluminum hydroxide, aluminum oxide, barium sulfate, or potassium titanate as long as the definition of the layered inorganic compound is satisfied. Among these compounds, a clay compound having water swellability and a compound containing aluminum hydroxide or aluminum oxide are especially preferable.

Such a clay compound is not particularly limited, and examples thereof include a compound in which a layer having a tetrahedral geometry constituted by the coordination of Si⁴⁺ to O²⁻ and a layer having an octahedral geometry constituted by the coordination of Al³⁺, Mg²⁺, Fe²⁺, Fe³⁺, or the like to O²⁻ and OH⁻ are bonded at 1:1 or 2:1 and stacked to form a layered structure. This clay compound may be a natural compound or may be a synthesized compound.

The aluminum hydroxide or the aluminum oxide may be fine particles dispersed in water. This may be a compound that is used in a sol state in which each type of aluminum hydroxide (amorphous aluminum hydroxide, gibbsite, beyerite, boehmite, or diaspore) in a hydrated form is subjected to hydrolysis and dehydration polycondensation in a solution so that a metal oxide and a metal hydroxide is dispersed, or may be manufactured by a hydrothermal synthesis method of allowing aluminum hydroxide to act on water under high temperature and high pressure conditions and dispersed in water.

The layered inorganic compound (C) is preferably a water-swellable clay mineral that swells in water and dissociates into layers in view of compatibility with an emulsion compound and the developing performance mentioned above, and is more preferably dispersed in a single layer or a plurality of layers in water.

The clay mineral is not particularly limited, and preferable examples thereof include layered silicate minerals such as kaolinite, dickite, halloysite, talc, pyrophyllite, saponite, hectorite, montmorillonite, beidellite, vermiculite, mica (isinglass), and palagonite.

Particularly, mica has a higher aspect ratio than that of other layered inorganic compounds (C) and is therefore preferable as the layered inorganic compound (C) because labyrinth effect is exerted more effectively and thus blocking properties produced together with an emulsion compound are especially high. Since an intermediate layer having narrow dispersion of an average particle diameter and containing a uniformly dispersed layered inorganic compound has high developing performance, water-swellable synthetic mica is more preferable.

The size of the layered inorganic compound (C) is preferably a size such that the layered inorganic compound (C) is uniformly arranged in the intermediate layer formed together with an emulsion compound, to thereby exert labyrinth effect more effectively and thus especially highly develops blocking properties.

From such viewpoints, the layered inorganic compound (C) preferably has an average particle diameter of 10 µm or less and a thickness of 500 nm or less, and more preferably has an average particle diameter of 10 µm or less and a thickness of 100 nm or less.

When the average particle diameter is 1 µm or more, sufficient blocking properties can be exerted in the intermediate layer. When the average particle diameter is 10 µm or less, generation of appearance unevenness can be prevented.

When the thickness is 10 nm or more, the shape of particles can be maintained, which is preferable in practical use. When the thickness is 500 nm or less, uniform coating is possible, and sufficient blocking properties can be exerted.

A commercially available product of the layered inorganic compound (C) is not particularly limited, and examples thereof include Micromica (synthetic mica) and Somasif (registered trade mark of Katakura & Co-op Agri Corporation, synthetic mica), KUNIPIA manufactured by KUNIMINE INDUSTRIES CO., LTD. (registered trade mark of KUNIMINE INDUSTRIES CO., LTD., montmorillonite), SUMECTON (registered trade mark of KUNIMINE INDUSTRIES CO., LTD.) SA (synthetic saponite); Bengel (registered trade mark of HOJUN Co., Ltd., purified product of natural bentonite) manufactured by HOJUN Co., Ltd., alumisol F-1000, F-3000, 5N, and 10N manufactured by Kawaken Fine Chemicals Co., Ltd., flake alumina powder Serath 00610, 02025, 02050, 05025, 05070, 07070, and 10030 manufactured by KINSEI MATEC CO., LTD., and TISMO D and TISMO N manufactured by Otsuka Chemical Co., Ltd.

A larger content of the layered inorganic compound (C) in the intermediate layer of the first embodiment improves blocking properties and developing performance. On the other hand, a smaller content of the layered inorganic compound (C) improves a coating property, and a film with a uniform film thickness tends to be easily obtained. Taking the balance among them into consideration, the content of the layered inorganic compound (C) is preferably 0.1% by mass or more and 20% by mass or less, more preferably 0.5% by mass or more and 10% by mass or less, and further preferably 1% by mass or more and 5% by mass or less based on the total amount of the intermediate layer.

### 1.3.6. Crosslinking agent (D)

In the flexographic printing raw plate of the first embodiment, the intermediate layer preferably includes a crosslinking agent (D). An emulsion compound can thereby be crosslinked, thereby further elevating Tg. Thus, the intermediate layer is easily fractured in a brittle manner at the time of development, and rapid development can be achieved. Furthermore, the strength and PH resistance of the intermediate layer can be enhanced.

The crosslinking agent (D) is not particularly limited as long as the crosslinking agent is capable of forming a crosslinked structure with the emulsion compound (A) and/or (B) mentioned above. Such a crosslinking agent is not particularly limited, and examples thereof include carbodiimide-based crosslinking agents; epoxy-based crosslinking agents; oxazoline-based crosslinking agents; ethyleneimine-based crosslinking agents; polyfunctional isocyanate-based crosslinking agents such as tolylene diisocyanate, trimethylolpropane tolylene diisocyanate, and diphenylmethane triisocyanate; metal salt-based crosslinking agents; metal chelate-based crosslinking agents; peroxide-based crosslinking agents; melamine resin; and phenol resin. A reactive group of such a crosslinking agent may be modified with a protective group in view of preservation stability.

It is preferable that the crosslinking agent (D) be chemically stably present without causing crosslinking in a coating liquid for use in the formation of the intermediate layer in a step of coating the infrared ablation layer described later with the coating liquid, and accelerate crosslinking under heat at the time of drying after coating. In this view, a carbodiimide-based crosslinking agent or a polyfunctional isocyanate-based crosslinking agent is preferably used, and, particularly, a compound having two or more carbodiimide groups in one molecule is further preferably used.

A commercially available product may be used as such a crosslinking agent. The commercially available product of the carbodiimide-based crosslinking agent is not particularly limited, and examples thereof include "DIC NAL(R) HX" manufactured by DIC Corp. and "Carbodilite (R)" manufactured by Nisshinbo Chemical Inc. Examples of the commercially available product of the isocyanate compound include Blocked Isocyanate SU-268A, MEIKANATE CX, DM-6400, and MEIKANATE TP-10 (manufactured by Meisei Chemical Works, Ltd.).

The content of the thermal crosslinking agent (D) is preferably 0.5% by mass or more and 15% by mass or less, more preferably 1% by mass or more and 10% by mass or less, and further preferably 2% by mass or more and 7% by mass or less based on the total amount of the intermediate layer. When the content of the crosslinking agent falls within the above range, developing performance is good while PH resistance is enhanced.

### 1.3.7. Binder polymer (E)

In the flexographic printing raw plate of the first embodiment, the intermediate layer may include, in addition to the emulsion compound (A) and (B), a binder polymer (E). The binder polymer is distinguished from the emulsion compound (A) and (B) in that the binder polymer is neither dispersed nor dissolved in water or is completely dissolved therein.

The binder polymer (E) is not particularly limited, and examples thereof include ethylene-vinyl alcohol copolymers, polymers such as polyvinyl alcohol, polyvinyl acetate, polyvinyl butyral, polyvinylpyrrolidone, polyvinyl chloride, polyvinylidene chloride, polyvinyl fluoride, polyvinylidene fluoride, polyacrylonitrile, polymethyl methacrylate, polyacetal, polycarbonate, polystyrene, polycarbonate, polyethylene, polypropylene, cellulose derivatives, polyester, polyamide, polyimide, polyurethane, silicone rubber, butyl rubber, and isoprene rubber, and copolymers thereof.

These binder polymers (E) may be used singly, or two or more thereof may be used in combination.

Among these binder polymers (E), a binder polymer that is completely dissolved in water is preferable for development with an aqueous developer in view of good developing performance. On the other hand, a binder polymer that is neither dispersed nor dissolved in water is preferable for enhancing moisture resistance.

Among those described above, polyamide is preferable. The polyamide is not particularly limited as long as the polymer has a polyamide bond, and examples thereof include lactam having 4 to 40 carbon atoms, aminocarboxylic acid, and an equimolar salt of diamine and dicarboxylic acid.

A conventionally known soluble synthetic polymer compound can be used as the polymer having a polyamide bond. Examples thereof include polyether amide (see, for example, Japanese Patent Laid-Open No. 55-79437), polyether ester amide (see, for example, Japanese Patent Laid-Open No. 58-113537), tertiary nitrogen-containing polyamide (see, for example, Japanese Patent Laid-Open No. 50-76055), ammonium salt type tertiary nitrogen atom-containing polyamide (see, for example, Japanese Patent Laid-Open No. 53-36555), an addition polymer of an amide compound having one or more amide bonds and an organic diisocyanate compound (see, for example, Japanese Patent Laid-Open No. 58-140737), and an addition polymer of diamine having no amide bond and an organic diisocyanate compound (see, for example, Japanese Patent Laid-Open No. 4-97154). These water-soluble polyamides may be used singly, or two or more types thereof may be used in combination.

The polyamide is preferably water-soluble polyamide consisting of a copolymer of an amine compound and/or an alkylene oxide compound and caprolactam. An intermediate layer that exhibits improved moisture resistance while maintaining blocking properties and developing performance which are advantages of the water-soluble polyamide can be provided. The inventors surmise that this is because an amine group or an alkylene oxide unit is highly compatible with the hydrophilic moiety of the emulsion compound (A) and improves the dispersibility of the emulsion compound (A) so that a high effect can be exerted.

The polyamide resin consisting of a copolymer of an amine compound and/or an alkylene oxide compound and caprolactam may be synthesized by a known approach illustrated in Japanese Patent Laid-Open No. 55-79437, or a commercially available product may be used. Examples of the commercially available product of the polyamide resin include "AQ Nylon(R)" manufactured by Toray Industries, Inc.

When the binder polymer (E) is contained in the intermediate layer, the content thereof can be arbitrarily set without impairing the advantageous effects of the present invention. A larger amount of the binder polymer added tends to improve blocking properties and adhesion and on the other hand, tends to reduce developing performance and softness. Taking the balance among them into consideration, the content of the binder polymer (E) is preferably 5% by mass or more and 70% by mass or less, and further preferably 10% by mass or more and 50% by mass or less based on the total amount of the intermediate layer.

### 1.3.8. Silicone compound (F)

The intermediate layer can be formed, for example, by application onto the infrared ablation layer. The intermediate layer preferably contains a silicone compound (F) in view of controlling surface energy for the purpose of uniformly applying the intermediate layer onto the infrared ablation layer.

The silicone compound (F) is not particularly limited, and preferable examples of the compound include a compound having a polyalkylsiloxane such as polydimethylsiloxane or polydiethylsiloxane in its main chain. The silicone compound may be a compound having polysiloxane structure at a part of its molecular.

A compound in which a certain organic group is introduced into polysiloxane structure can also be used. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both of a side chain and a terminal of polysiloxane, and the like can be used. A silicone compound into which an organic group is introduced is preferably used in view of ensuring adhesiveness between the intermediate layer and the photosensitive resin composition layer.

The organic group to be introduced into polysiloxane structure is not particularly limited, and examples thereof include an amino group, a carboxy group, a carbinol group, an aryl group, an alkyl group, an alkoxycarbonyl group, an alkoxy group, a linear or branched alkyl group substituted with at least one aryl group, and a polyoxyalkylene group (hereinafter also referred to as a polyether group).

The silicone compound (F) is not particularly limited, and examples thereof include various kinds of organic group-substituted silicone oil manufactured by Shin-Etsu Chemical Co., Ltd., Wacker Asahikasei Silicone Co., Ltd., GE Toshiba Silicones Co., Ltd., and Dow Corning Toray Silicone Co., Ltd.

The content of the silicone compound (F) is preferably 0.01% by mass or more and 10% by mass or less, more preferably 0.5% by mass or more and 8.0% by mass or less, and further preferably 1.0% by mass or more and 6.0% by mass or less based on the total amount of the intermediate layer.

### 1.3.9. Surfactant

The intermediate layer can be formed, for example, by application onto the infrared ablation layer. The intermediate layer preferably contains a surfactant in view of controlling surface energy for the purpose of uniformly applying the intermediate layer onto the infrared ablation layer.

The surfactant is not particularly limited, and examples thereof can include an anionic surfactant, an ionic surfactant, a nonionic surfactant, an anionic reactive surfactant, and a nonionic reactive surfactant. These surfactants may be used singly, or two or more types thereof may be used in combination.

The anionic surfactant is not particularly limited, and examples thereof include sodium polyoxyethylene styrenated phenyl ether sulfate, a sodium polyoxyalkylene branched decyl ether sulfate, an ammonium polyoxyethylene isodecyl ether sulfate, a sodium polyoxyethylene tridecyl ether sulfate, a sodium polyoxyethylene alkyl (C8-C20) ether sulfate, an ammonium polyoxyethylene oleyl cetyl ether sulfate, a sodium polyoxyethylene oleyl cetyl ether sulfate, a polyoxyethylene tridecyl ether phosphate, a polyoxyethylene alkyl (C2-C16) ether phosphate, a polyoxyethylene alkyl (C2-C16) ether phosphate-monoethanolamine salt, a sodium alkyl (C2-C16) phosphate, an alkyl (C2-C16) phosphate-monoethanolamine salt, disodium lauryl sulfosuccinate, a disodium lauryl polyoxyethylene sulfosuccinate, a disodium polyoxyethylene alkyl (C2-C20) sulfosuccinate, a sodium linear alkylbenzene sulfonate, a linear alkylbenzene sulfonate, a sodium alpha-olefin sulfonate, phenolsulfonic acid, sodium dioctyl sulfosuccinate, sodium lauryl sulfate, and a higher fatty acid potassium salt.

The ionic surfactant is not particularly limited, and examples thereof include ionic surfactants such as an alkyl (C8-C20) trimethylammonium chloride, an alkyl (C8-C20) dimethylethylammonium chloride, didecyldimethylammonium chloride, lauryl dimethyl benzyl ammonium chloride, stearyl dimethyl hydroxyethyl ammonium para-toluene sulfonate, stearyl dimethyl aminopropylamide, tributyl benzyl ammonium chloride, lauryl dimethyl aminoacetic acid betaine, laurylamide propyl betaine, cocamidepropyl betaine, octanamide propyl betaine, and lauryl dimethyl amine oxide.

The nonionic surfactant is not particularly limited, and examples thereof include nonionic surfactants such as a polyoxyalkylene tridecyl ether, a polyoxyethylene isodecyl ether, a polyoxyalkylene lauryl ether, a polyoxyalkylene alkyl ether, a mixture of a polyoxyalkylene ether and a polyether polyol, a polyether polyol, a polyoxyethylene sulfonated phenyl ether, a polyoxyethylene naphthyl ether, phenoxyethanol, a polyoxyethylene phenyl ether, a polyoxyethylene polyoxypropylene glycol, a polyoxyethylene lauryl ether, a polyoxyethylene oleyl cetyl ether, a polyoxyethylene oleate, a polyoxyethylene distearate, a polyoxyethylene glyceryl isostearate, polyoxyethylene-cured castor oil, coconut fatty acid diethanolamide, polyoxyethylene alkylamine, sorbitan trioleate, sorbitan sesquioleate, sorbitan monooleate, sorbitan monococoate, sorbitan monocaprylate, a polyoxyethylene sorbitan monococoate, a polyoxyethylene sorbitan monostearate, a polyoxyethylene sorbitan monooleate, octyl polyglycoside, a butyl polyglycoside, sucrose benzoate, sucrose acetate, and a sucrose fatty acid ester.

The anionic reactive surfactant is not particularly limited, and examples thereof include anionic reactive surfactants such as an ammonium polyoxyethylene-1-(allyloxymethyl)alkyl ether sulfate and an ammonium polyoxyethylene nonyl propenyl phenyl ether sulfate.

The nonionic reactive surfactant is not particularly limited, and examples thereof include nonionic reactive surfactants such as a polyoxyethylene nonyl propenyl phenyl ether.

The surfactant may be added to another layer (for example, the photosensitive resin composition layer) in addition to the intermediate layer. The content of the surfactant is preferably 0.1% by mass or more and 5.0% by mass or less, more preferably 0.5% by mass or more and 3.0% by mass or less, and further preferably 0.5% by mass or more and 2.0% by mass or less based on 100% by mass of the total amount of materials of a layer to which the surfactant is added. When 0.1% by mass or more of the surfactant is contained, cleaning speed at the time of development after exposure can be improved. When 5.0% by mass or less of the surfactant is contained, swelling of the flexographic printing raw plate tends to be suppressed.

### 1.4. Infrared ablation layer

The flexographic printing raw plate of the first embodiment has an infrared ablation layer on the intermediate layer. The infrared ablation layer can be subjected to lithography processing using infrared light and serves as a mask image when the photosensitive resin composition layer is exposed and cured. At the time when an unexposed part of the photosensitive resin composition layer is washed out after completion of the exposure, this infrared ablation layer is simultaneously removed.

The infrared ablation layer is preferably composed of a binder polymer and an infrared absorber.

Examples of the binder polymer are not particularly limited, and include a polyamide, a polyester, and a copolymer of a monovinyl-substituted aromatic hydrocarbon and a conjugated diene. Especially, a copolymer of a monovinyl-substituted aromatic hydrocarbon such as styrene, α-methyl styrene, and vinyltoluene and a conjugated diene such as 1,3-butadiene and isoprene are preferable. When the infrared ablation layer is formed by using such a binder polymer, affinity for the intermediate layer is high and adhesion is thus good.

A larger film thickness of the infrared ablation layer in the flexographic printing raw plate of the first embodiment is preferable in view of securing a light shielding property against ultraviolet light in a step of performing an exposure treatment of the flexographic printing raw plate, and a smaller film thickness is preferable in view of enhancing developing performance. From such viewpoints, the film thickness of the infrared ablation layer is preferably 0.1 µm or more and 20 µm or less, more preferably 0.5 µm or more and 15 µm or less, and further preferably 1.0 µm or more and 10 µm or less.

As for a non-infrared radiation shielding effect of the infrared ablation layer, the optical density of the infrared ablation layer is preferably 2 or more, and more preferably 3 or more. The optical density can be measured using D200-II Transmission Densitometer (manufactured by GretagMacbeth LLC). The optical density is so-called luminous (ISO visual), and the light to be measured is in a wavelength region on the order of 400 to 750 nm.

A simple substance or compound having strong absorption characteristics at a wavelength in a range of usually 750 nm to 2000 nm is used as an infrared absorber. It is preferable that the infrared absorber also serve as a non-infrared radiation shielding substance, though the infrared absorber and the non-infrared radiation shielding substance may be individually added.

It is preferable that the infrared absorber have a high absorbing property in an infrared region and be uniformly dispersible in the infrared ablation layer. Such a substance is not particularly limited, and examples thereof include inorganic pigments such as carbon black, graphite, iron oxide, chromium oxide, and copper chromite; and colorants such as phthalocyanine and substituted phthalocyanine derivatives, cyanine colorant, merocyanine colorant and polymethine colorant, and metal thiolate colorant.

A substance reflecting or absorbing an ultraviolet beam can be used as the non-infrared radiation shielding substance. Preferable examples thereof include, but are not particularly limited to, carbon black, ultraviolet absorbers, and graphite.

These infrared absorbers or non-infrared radiation shielding substances may be used singly, or two or more thereof may be mixed and used.

The infrared absorber is especially preferably carbon black which also has a non-infrared radiation shielding effect, is easily available, and is inexpensive. The particle diameter of the carbon black can be selected within an arbitrary range. In general, a smaller particle diameter enhances sensitivity to infrared radiation and deteriorates dispersibility. From these viewpoints, the particle diameter of the carbon black is preferably 13 nm or more and 80 nm or less, more preferably 15 nm or more and 70 nm or less, and further preferably 18 nm or more and 60 nm or less.

The carbon black is not particularly limited and is classified into, for example, furnace black, channel black, thermal black, acetylene black, and lamp black according to a manufacturing method thereof. Furnace black is preferable in view of availability and diversity.

The infrared ablation layer may contain a dispersant for the purpose of assisting the dispersion of carbon black. The dispersant is not particularly limited and is preferably a compound having an adsorbing moiety capable of interacting with a surface functional group of an infrared absorber, and a resin-compatible moiety compatible with a resin.

The adsorbing moiety of the dispersant is not particularly limited, and examples thereof include an amino group, an amide group, a urethane group, a carboxyl group, a carbonyl group, a sulfone group, and a nitro group. An amino group, an amide group, or a urethane group is preferable.

The resin-compatible moiety is not particularly limited, and examples thereof include saturated alkyl, unsaturated alkyl, polyether, polyester, poly(meth)acryl, and polyol.

### 2. Second embodiment: flexographic printing raw plate

The flexographic printing raw plate of the second embodiment comprises a support, a photosensitive resin composition layer on the support, an intermediate layer, and an infrared ablation layer in the presented order, wherein the intermediate layer has a water contact angle of 70° or more and 90° or less 3 minutes after dropwise addition at an interface with the infrared ablation layer.

In the second embodiment, the same configuration illustrated in the first embodiment can be adopted except that the water contact angle 3 minutes after dropwise addition on the intermediate layer surface at an interface between the intermediate layer and the infrared ablation layer is 70° or more and 90° or less.

Examples of the support, the photosensitive resin composition layer, and the infrared ablation layer can include the same as those of the first embodiment. The intermediate layer may be configured in the same manner as in the first embodiment as long as the water contact angle described above is satisfied. Examples of the components for use in the intermediate layer and the configuration thereof include the same as those described above. Examples of the physical characteristics such as a water contact angle and tensile physical properties can also include the same numeric values as above. For measurement methods and adjustment methods thereof, also see the first embodiment.

### 3. Manufacturing method of flexographic printing raw plate

The flexographic printing raw plate of the present embodiment can be manufactured by various methods without particular limitations as long as the methods involve stacking the photosensitive resin composition layer, the intermediate layer, and the infrared ablation layer on the support. Specific examples thereof include the following methods.

First, a photosensitive resin composition layer is obtained by a method of dissolving a starting material of the photosensitive resin composition which is a material of the photosensitive resin composition layer in an appropriate solvent, for example, a solvent such as chloroform, tetrachloroethylene, methyl ethyl ketone, or toluene, mixing the solution, casting it into a mold, and evaporating the solvent, thereby shaping a plate, or a method of kneading the starting material in a kneader, a roll mill, or a screw extruder without the use of a solvent, and then molding the resultant into a desired thickness in a calender roll, a press, or the like, and this layer is laminated with a support to obtain a stack of the support and the photosensitive resin composition layer.

Thereafter, an intermediate layer and an infrared ablation layer are formed on the photosensitive resin composition layer. To provide the intermediate layer and the infrared ablation layer on the surface of the photosensitive resin composition layer, for example, a component that constitutes the intermediate layer and a component that constitutes the infrared ablation layer can each be dispersed or dissolved in an appropriate solvent by forced stirring with a stirring blade or ultrasonic stirring, or preliminarily kneaded using an extruder or a kneader and then dispersed or dissolved in an appropriate solvent to obtain a predetermined dispersion or solution, followed by direct coating of the photosensitive resin composition layer with the dispersion or the solution to form an intermediate layer and the infrared ablation layer.

Also, a cover sheet made of, for example, polyester or polypropylene may be provided on the infrared ablation layer.

In another method, a predetermined cover sheet is coated with a material that constitutes the infrared ablation layer to obtain a film having the infrared ablation layer, followed by coating of the infrared ablation layer with a material that constitutes the intermediate layer to obtain a cover film in which the infrared ablation layer and the intermediate layer are stacked on the cover sheet. Thereafter, this cover film can be laminated or pressure-bonded to the photosensitive resin composition layer side of the stack of the support and the photosensitive resin composition layer to form the intermediate layer and the infrared ablation layer on the photosensitive resin composition layer.

The cover film or the support can usually be allowed to adhere to the photosensitive resin composition layer by roll lamination after sheet formation of the photosensitive resin composition layer, laminated, and then pressed by heating to obtain a flexographic printing raw plate with better thickness precision.

### 4. Manufacturing method of a flexographic printing plate

The manufacturing method of a flexographic printing plate of the present embodiment may be a method including: a back exposure step of irradiating the flexographic printing raw plate with ultraviolet light from the support side; an infrared irradiation step of irradiating the infrared ablation layer with infrared light for lithography processing of a pattern; a relief exposure step of selectively performing exposure by irradiating the photosensitive resin composition layer with ultraviolet light via the intermediate layer using the infrared ablation layer in which the pattern is formed by lithography processing as a mask; and a development step of removing an unexposed part of the infrared ablation layer, the intermediate layer, and the photosensitive resin composition layer.

Thereafter, a step of performing a post exposure treatment is performed as needed to obtain a flexographic printing plate (letterpress printing plate) having a cured product of the photosensitive resin composition layer.

The surface of the printing plate may be brought into contact with a liquid containing a silicone compound and/or a fluorine compound in view of conferring peelability.

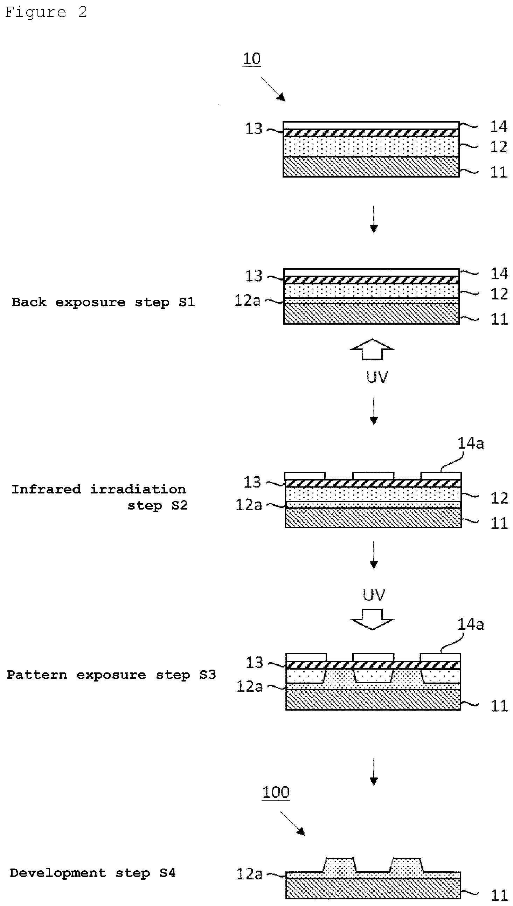

Figure 2 shows a schematic view showing a manufacturing method of a flexographic printing plate using the flexographic printing raw plate of the present embodiment. Hereinafter, each step will be described in detail.

### 4.1. Back exposure step

First, in back exposure step S1, the entire surface of photosensitive resin composition layer 12 is subjected to ultraviolet light exposure (back exposure) through support 11 of flexographic printing raw plate 10 and cured to form a thin uniform cured layer. In this respect, an exposure method is not particularly limited and can be conducted using a known irradiation unit.

Ultraviolet light with a wavelength of 150 to 500 nm can be used as the ultraviolet light, and, particularly, ultraviolet light of 300 to 400 nm can be preferably used.

A light source of ultraviolet light is not particularly limited, and a low pressure mercury lamp, a high pressure mercury lamp, an ultrahigh pressure mercury lamp, a metal halide lamp, a xenon lamp, a zirconium lamp, a carbon arc lamp, a fluorescent lamp for ultraviolet light, or a LED lamp, for example, can be used. An ultraviolet exposure unit is commercially available, and AFP 1216 EHQ (manufactured by Asahi Kasei Corp.) or XPS Crystal (manufactured by ESKO Graphics Co., Ltd.), for example, can be used.

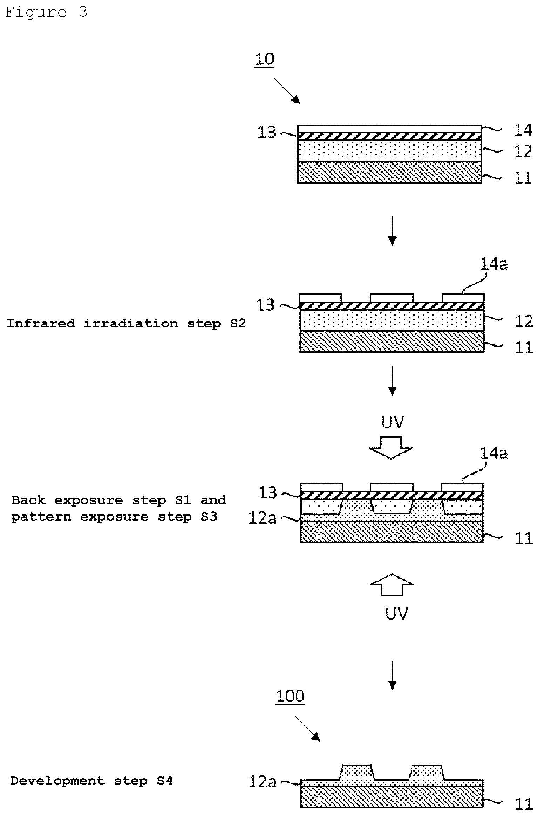

The back exposure step may be conducted before an infrared irradiation step, or as shown in Figure 3, the back exposure step S1 and pattern step S3 may be simultaneously conducted. Figure 3 shows the same as that shown in Figure 2 except for the order of steps.

### 4.2. Infrared irradiation step

Next, in infrared irradiation step S2, negative pattern 14a is created in infrared ablation layer 14 by laser lithography (i.e. laser ablation). When the flexographic printing raw plate 10 has a cover film on the infrared ablation layer 14, the cover film is first peeled before infrared irradiation. Thereafter, the infrared ablation layer is subjected to pattern irradiation with infrared light to form a mask on the photosensitive resin composition layer.

Preferable examples of the infrared laser include ND/YAG laser (for example, 1064 nm) and diode laser (for example, 830 nm). A laser system appropriate for CTP plate making technology is commercially available, and diode laser system CDI Spark (ESKO Graphics Co., Ltd.), for example, can be used. This laser system includes a rotary cylindrical drum which holds a flexographic printing raw plate, an IR laser irradiation apparatus, and a layout computer, and image information is directly sent to the laser apparatus from the layout computer.

### 4.3. Exposure step

In exposure step S3, image exposure (relief exposure) is conducted on the photosensitive resin composition layer 12 via the intermediate layer 13 using infrared ablation layer 14a in which the negative pattern is formed as a mask to form cured photosensitive resin composition layer 12a.

In this respect, light that has passed through the mask accelerates curing reaction of the photosensitive resin composition layer, and concavity and convexity of the pattern formed in the infrared ablation layer is transferred in an inverted manner to the photosensitive resin composition layer. Irradiation with ultraviolet light may be conducted on the entire surface of the flexographic printing raw plate.

The exposure step can be performed in a state where the plate is attached to a laser cylinder. In general, the plate is removed from a laser apparatus and irradiated using a conventional irradiation unit. The same unit as that used in ultraviolet irradiation from the support side can be used as the irradiation unit.

When the flexographic printing raw plate of the present embodiment has an intermediate layer such as an oxygen inhibiting layer or an adhesive layer and the amount of ultraviolet light absorbed in the intermediate layer as an oxygen inhibiting layer is too large to ignore in the exposure step, it is preferable to appropriately adjust an ultraviolet dose by taking into consideration in advance the amount of ultraviolet light to be absorbed by the intermediate layer as an oxygen inhibiting layer.

### 4.4. Development step

Thereafter, a development step is performed. In the development step, an unexposed part of the infrared ablation layer 14a, the intermediate layer 13, and the photosensitive resin composition layer 12 is removed. A conventionally known method can be applied to a development method. Specifically, the flexographic printing raw plate is exposed as described above, and the unexposed part is then washed away with a solvent for solvent development or a developer for water development. Alternatively, an unexposed part heated to 40°C to 200°C is brought into contact with a predetermined absorption layer capable of absorbing the unexposed part and the unexposed part can be removed by removing the absorption layer.

Thereafter, post treatment exposure is then conducted as needed to manufacture a flexographic printing plate. As the post treatment exposure, a method involving irradiating the surface with light having a wavelength of 300 nm or less is exemplified. Light having a wavelength of more than 300 nm may be used in combination as needed.

In the development step, an aqueous developer or a solvent-based developer can be used. Among them, an aqueous developer is preferably used in view of environmental harmony.

The solvent-based developer for use in solvent development of the unexposed part is not particularly limited, and examples thereof include esters such as heptylacetate and 3-methoxybutyl acetate; hydrocarbons such as a petroleum fraction, toluene, and decalin; and a mixture of alcohols such as propanol, butanol, and pentanol with a chlorine-based organic solvent such as tetrachloroethylene. Washout of the unexposed part can be carried out by spraying from a nozzle or brushing with a brush.

The aqueous developer for use in water development of the unexposed part is a developer containing water as a main component. The aqueous developer may be water itself or may be an alkaline aqueous solution or a neutral detergent. Such an aqueous developer is not particularly limited, and a mixture of water with a surfactant such as a nonionic surfactant and an anionic surfactant, a pH adjuster, a cleaning accelerator, and the like, for example, can be used.

Examples of the surfactant include an anionic surfactant, an amphoteric surfactant, and a nonionic surfactant. These surfactants may be used singly, or two or more thereof may be mixed and used.

The anionic surfactant is not particularly limited, and examples thereof include a sulfuric acid ester salt, a higher alcohol sulfuric acid ester, a higher alkyl ether sulfuric acid ester salt, a sulfated olefin, an alkylbenzenesulfonate, an α-olefinsulfonate, a phosphoric acid ester salt, and a dithiophosphoric acid ester salt.

The amphoteric surfactant is not particularly limited, and examples thereof include an amino acid type amphoteric surfactant and a betaine type amphoteric surfactant.

The nonionic surfactant is not particularly limited, and examples thereof include polyethylene glycol type surfactants such as a higher alcohol-ethylene oxide adduct, an alkyl phenol-ethylene oxide adduct, a fatty acid-ethylene oxide adduct, a polyhydric alcohol fatty acid ester-ethylene oxide adduct, a higher alkylamine-ethylene oxide adduct, a fatty acid amide-ethylene oxide adduct, and a polypropylene glycol-ethylene oxide adduct; and polyhydric alcohol type surfactants such as a glycerol fatty acid ester, a pentaerythritol fatty acid ester, fatty acid esters of sorbitol and sorbitan, an alkyl ester of a polyhydric alcohol, and fatty acid amides of alkanolamines.

The alkaline aqueous solution contains a pH adjuster.

The pH adjuster may be any of organic and inorganic materials and is preferably a pH adjuster that can adjust pH to 9 or more. The pH adjuster is not particularly limited, and examples thereof include sodium hydroxide, sodium carbonate, potassium carbonate, sodium silicate, sodium metasilicate, and sodium succinate.

Development can also be performed by heat. In the case of heat development, no solvent is used. Instead, the photosensitive resin composition layer and the intermediate layer are brought into contact with an absorbent material after image exposure and then heated. Examples of the absorption layer of heat development include nonwoven fabric materials, paper materials, fibrous woven fabrics, open cell foams, and porous materials. Among them, the absorption layer is preferably a nonwoven fabric material made of nylon, polyester, polypropylene, or polyethylene, or a combination of these nonwoven fabric materials. The absorption layer is especially preferably a continuous nonwoven web of nylon or polyester.

### 5. Flexographic printing method

The flexographic printing method of the present embodiment comprises: a printing plate manufacturing step of manufacturing a flexographic printing plate by the manufacturing method of a flexographic printing plate using the flexographic printing raw plate; and a step of performing printing using the flexographic printing plate manufactured in the printing plate manufacturing step.

The step of performing printing using the flexographic printing plate is not particularly limited as long as the method involves allowing ink to attach to a convex part of the flexographic printing plate, and transferring the ink to a base material.

### Examples

Hereinafter, the present invention will be described in detail with reference to specific working examples and comparative examples. However, the present invention is not limited to the following examples at all.

### [Manufacturing Example 1]

### (Synthesis of hydrophilic copolymer)

To a pressure resistant reaction vessel provided with a stirring device and a jacket for temperature adjustment were initially added 125 parts by mass of water and, as a reactive emulsifier, 2 parts by mass of "ADEKA REASOAP" (manufactured by ADEKA Corporation), an ammonium salt of (α-sulfo(1-nonylphenoxy)methyl-2-(2-propenyloxy)ethoxy-poly(oxy-1,2-ethanediyl). The inside temperature was increased to 80°C; and an oil-based mixture liquid including 2 parts by mass of t-dodecyl mercaptan and a monomer mixture including 10 parts by mass of styrene, 60 parts by mass of butadiene, 23 parts by mass of butyl acrylate, 5 parts by mass of methacrylic acid, and 2 parts by mass of acrylic acid and an aqueous solution including 28 parts by mass of water, 1.2 parts by mass of sodium peroxodisulfate, and 0.2 parts by mass of sodium hydroxide, and 2 parts by mass of an ammonium salt of (α-sulfo(1-nonylphenoxy)methyl-2-(2-propenyloxy)ethoxy-poly(oxy-1,2-ethanediyl) were added to the reaction vessel over five hours and six hours, respectively, at a constant flow rate.

Thereafter, the temperature was continuously kept at 80°C for one hour to complete polymerization reaction and obtain a copolymer latex, followed by cooling. Furthermore, pH of the produced copolymer latex was adjusted to 7 by sodium hydroxide, unreacted monomers were then removed by a steam stripping method followed by filtration with a 200 mesh metallic mesh, and the solid concentration of the filtrate was finally adjusted to 40% by mass to obtain an aqueous dispersion of a hydrophilic copolymer. The obtained aqueous dispersion of the hydrophilic copolymer was dried up by a vacuum dryer at 50°C to consequently remove water therefrom to thereby obtain the hydrophilic copolymer.

### [Manufacturing Example 2]

### (Production of base film (support))

As a solution for an adhesive layer to coat a support (base film), 55 parts by mass of Tufprene 912 (manufactured by Asahi Kasei Corp., trade name), which is a block copolymer of styrene and 1,3-butadiene, 38 parts by mass of paraffin oil (average carbon number: 33, average molecular weight: 470, and density at 15°C: 0.868), 2.5 parts by mass of 1,9-nonanediol diacrylate, 1.5 parts by mass of 2,2-dimethoxy-phenylacetophenone, 3 parts by mass of EPOXY ESTER 3000M (manufactured by Kyoeisha Chemical Co., Ltd., trade name), and 1.5 parts by mass of VALIFAST YELLOW-3150 (manufactured by ORIENT CHEMICAL INDUSTRIES CO., LTD., trade name) were dissolved in toluene to obtain a solution with a solid content of 25%.

Thereafter, the obtained solution was applied to one side of a polyester film having a thickness of 100 µm using a knife coater so as to achieve an ultraviolet transmittance (UV transmittance) of 10% followed by drying at 80°C for one minute to obtain a support (base film) having an adhesive layer. The UV transmittance of the support was calculated from transmission intensity measured by UV illuminometer MO-2 model (manufactured by ORC MANUFACTURING CO., LTD., trade name, UV-35 filter) using ultraviolet light exposure apparatus AFP-1500 (manufactured by Asahi Kasei Corp., trade name).

### [Manufacturing Example 3]

### (Production of film having infrared ablation layer)

After 65% by mass of Asaflex 810 (manufactured by Asahi Kasei Corp., trade name), which is a block copolymer of styrene and 1,3-butadiene, and 35% by mass of carbon black as an infrared sensitive substance were kneaded with a kneader and cut into a pellet, 90 parts by mass of this pellet and 10 parts by mass of 1,6-hexanediol adipate were dissolved, utilizing ultrasonic waves, in a solvent mixture prepared at a mass ratio of ethyl acetate/butyl acetate/propyleneglycol monomethyl ether acetate = 50/30/20 to prepare a uniform solution with a solid content of 12% by mass.

Thereafter, this solution was applied onto a polyester film to be a cover sheet with a thickness of 100 µm to achieve an applied amount after drying of 4 to 5 g/m² using a knife coater followed by drying at 80°C for one minute to obtain a film having an ultraviolet shielding layer (infrared ablation layer) capable of ablating by infrared light. The optical density of the film having the infrared ablation layer measured by DM-500 (manufactured by Dainippon Screen Mfg. Co., Ltd., trade name) was 3 to 4.

### [Manufacturing Example 4]

### (Production of cover film (film having intermediate layer and infrared ablation layer))

To a solution prepared at a mass ratio of ethanol/distilled water = 10/90 were added 90% by mass of a polyester emulsion compound PLAS COAT Z730 (manufactured by Goo Chemical Co., Ltd., Tg: 46°C, number average molecular weight: 3,000, acid value: 40 mg KOH/g), 5% by mass of a polyurethane emulsion compound WLS-202 (manufactured by DIC Corp., Tg: -50°C), and 5% by mass of polyether-modified silicone oil KF-351A (manufactured by Shin-Etsu Chemical Co., Ltd.) followed by stirring to prepare an intermediate layer coating liquid.

Thereafter, the intermediate layer coating liquid was applied onto the film having the infrared ablation layer produced in Manufacturing Example 3 described above, on the infrared ablation layer side thereof, so that the thickness after drying became 3 µm using a bar coater. A cover film having an intermediate layer and the infrared ablation layer was obtained by subsequent drying at 100°C for four minutes.

### [Example 1]

### (Production of flexographic printing raw plate)

After mixing 32 parts by mass of the hydrophilic copolymer obtained in Manufacturing Example 1 described above and 28 parts by mass of a styrene-butadiene-styrene copolymer [D-KX405: manufactured by Kraton Corporation] at 140°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of carbinol-modified silicone oil [KF-6000: manufactured by Shin-Etsu Chemical Co., Ltd.] was added little by little over 15 minutes, and additional kneading was carried out for 20 minutes after completion of addition to obtain photosensitive resin composition 1.

Thereafter, the photosensitive resin composition was put into an extrusion molding machine, and extruded and molded from a T-shaped die, and on a face of the resulting photosensitive resin composition 1, the base film (support) having the adhesive layer obtained in Manufacturing Example 2 described above was laminated so that the adhesive layer contacted the photosensitive resin composition layer. A mold release film (manufactured by Mitsubishi Chemical Corporation, DIAFOIL MRV100) was laminated on the face of the photosensitive resin composition layer opposed from the side on which the support was laminated, to obtain a stack of the support and the photosensitive resin composition layer.

Thereafter, the mold release film was peeled, and the intermediate layer obtained in Manufacturing Example 4 described above and the cover film having the infrared ablation layer were laminated so that the intermediate layer contacted the photosensitive resin composition layer to obtain a flexographic printing raw plate.

### (Manufacturing of flexographic printing plate)

The flexographic printing raw plate was exposed from the side of the support (PET coated with an adhesive) using an ultraviolet light exposure apparatus "JE-A2-SS" (manufactured by Nihon Denshi Seiki Co., Ltd., trade name) so that a pattern height (RD) after curing was about 0.5 mm.

Thereafter, the cover sheet of the infrared ablation layer was peeled, a halftone image (AM 150 lpi, data 25% halftone) was drawn on the infrared ablation layer using CDI Spark 4260 (manufactured by ESKO Graphics Co., Ltd., trade name), and the infrared ablation layer side was exposed at 8000 mJ under an air atmosphere using the above-described exposure apparatus.

After exposure, an aqueous solution (aqueous developer) of 1% polyoxyalkylene alkyl ether (NEWCOL 2308: manufactured by Nippon Nyukazai Co., Ltd.) and 1% potassium carbonate was prepared, and an unexposed part was removed by washing (development) at 40°C using a cleaning machine manufactured by Nihon Denshi Seiki Co., Ltd. (JOW-A3-P). After drying at 50°C for 10 minutes, post exposure was performed with an ultraviolet sterilization lamp and an ultraviolet chemical lamp for removal of surface tackiness to obtain a flexographic printing plate.

### [Example 2]

When the intermediate layer coating liquid described above in Manufacturing Example 4 was prepared in the manufacturing of a flexographic printing raw plate, to a solution prepared at a mass ratio of ethanol/distilled water = 10/90 were added 75% by mass of the polyester emulsion PLAS COAT Z730, 15% by mass of the polyurethane emulsion compound WLS-202, and 10% by mass of the polyether-modified silicone oil KF-351A followed by stirring to prepare an intermediate layer coating liquid.

Thereafter, when the intermediate layer was applied, the application was performed, so that the film thickness after drying became 15 µm. A flexographic printing raw plate and a flexographic printing plate were obtained under the same conditions as in Example 1 except for the above.

### [Example 3]

When the intermediate layer coating liquid described above in Manufacturing Example 4 was prepared in the manufacturing of a flexographic printing raw plate, to a solution prepared at a mass ratio of ethanol/distilled water = 10/90 were added 75% by mass of the polyester emulsion PLAS COAT Z730, 15% by mass of a styrene-butadiene copolymer latex A-7090 (manufactured by Asahi Kasei Corp., Tg: 6°C), and 10% by mass of the polyether-modified silicone oil KF-351A followed by stirring to prepare an intermediate layer coating liquid. Thereafter, when the intermediate layer was applied, the application was performed, so that the film thickness after drying became 30 µm. A flexographic printing raw plate and a flexographic printing plate were obtained under the same conditions as in Example 1 except for the above.

### [Example 4]

When the intermediate layer coating liquid described above in Manufacturing Example 4 was prepared in the manufacturing of a flexographic printing raw plate, to a solution prepared at a mass ratio of ethanol/distilled water = 10/90 were added 60% by mass of a polyester emulsion compound Vylonal MD-2000 (manufactured by Toyobo Co., Ltd., Tg: 67°C, number average molecular weight: 18,000, acid value: < 2 mg KOH/g), 35% by mass of the polyurethane emulsion compound WLS-202, and 5% by mass of the polyether-modified silicone oil KF-351A followed by stirring to prepare an intermediate layer coating liquid. Thereafter, when the intermediate layer was applied, the application was performed, so that the film thickness after drying became 10 µm. A flexographic printing raw plate and a flexographic printing plate were obtained under the same conditions as in Example 1 except for the above.

### [Example 5]

In the manufacturing of a flexographic printing raw plate, 60% by mass of a polyester emulsion compound PLAS COAT Z-221 (manufactured by Goo Chemical Co., Ltd., Tg: 47°C, number average molecular weight: 14,000, acid value: < 5 mg KOH/g), 30% by mass of the polyurethane emulsion compound WLS-202, and 10% by mass of the polyether-modified silicone oil KF-351A were added and stirred to prepare an intermediate layer coating liquid. Thereafter, when the intermediate layer was applied, the application was performed, so that the film thickness after drying became 2.5 µm. A flexographic printing raw plate and a flexographic printing plate were obtained under the same conditions as in Example 1 except for the above.

### [Example 6]

When the intermediate layer coating liquid described above in Manufacturing Example 4 was prepared in the manufacturing of a flexographic printing raw plate, to a solution prepared at a mass ratio of ethanol/distilled water = 10/90 were added 50% by mass of a polyester emulsion compound PLAS COAT Z-687 (manufactured by Goo Chemical Co., Ltd., Tg: 110°C, number average molecular weight: 26,000, acid value: < 5 mg KOH/g), 40% by mass of the polyurethane emulsion compound WLS-202, and 10% by mass of the polyether-modified silicone oil KF-351A followed by stirring to prepare an intermediate layer coating liquid. Thereafter, when the intermediate layer was applied, the application was performed, so that the film thickness after drying became 2.1 µm. A flexographic printing raw plate and a flexographic printing plate were obtained under the same conditions as in Example 1 except for the above. A flexographic printing raw plate and a flexographic printing plate were obtained under the same conditions as in Example 1 except for the above.

### [Example 7]

When the intermediate layer coating liquid described above in Manufacturing Example 4 was prepared in the manufacturing of a flexographic printing raw plate, to a solution prepared at a mass ratio of ethanol/distilled water = 10/90 were added 79% by mass of the polyester emulsion PLAS COAT Z730, 10% by mass of the polyurethane emulsion compound WLS-202, 1% by mass of water-swellable synthetic mica Somasif MEB-3 (manufactured by Katakura & Co-op Agri Corp.), and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 8]

When the intermediate layer coating liquid described above in Manufacturing Example 4 was prepared in the manufacturing of a flexographic printing raw plate, to a solution prepared at a mass ratio of ethanol/distilled water = 10/90 were added 60% by mass of the polyester emulsion PLAS COAT Z730, 26% by mass of the polyurethane emulsion compound WLS-202, 4% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 9]

When the intermediate layer coating liquid described above in Manufacturing Example 4 was prepared in the manufacturing of a flexographic printing raw plate, to a solution prepared at a mass ratio of ethanol/distilled water = 10/90 were added 60% by mass of the polyester emulsion compound PLAS COAT Z-221, 26% by mass of the polyurethane emulsion compound WLS-202, 4% by mass of water-dispersible aluminum hydroxide Alumina Sol 10N (manufactured by Kawaken Fine Chemicals Co., Ltd.), and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 10]

When the intermediate layer coating liquid described above in Manufacturing Example 4 was prepared in the manufacturing of a flexographic printing raw plate, to a solution prepared at a mass ratio of ethanol/distilled water = 10/90 were added 80% by mass of Vylonal MD-2000, 15% by mass of a styrene-butadiene copolymer latex (emulsion compound (B)) L-7430 (manufactured by Asahi Kasei Corp., Tg: -5°C), and 5% by mass of KF-351A followed by stirring to prepare an intermediate layer coating liquid. A flexographic printing raw plate and a flexographic printing plate were obtained under the same conditions as in Example 1 except for the above.

### [Example 11]

When the intermediate layer coating liquid described above in Manufacturing Example 4 was prepared in the manufacturing of a flexographic printing raw plate, to a solution prepared at a mass ratio of ethanol/distilled water = 10/90 were added 40% by mass of the polyester emulsion PLAS COAT Z-730, 42% by mass of the polyurethane emulsion compound WLS-202, 8% by mass of water-swellable synthetic mica Somasif ME300B4T (manufactured by Katakura & Co-op Agri Corp.), and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 12]

When the intermediate layer coating liquid described above in Manufacturing Example 4 was prepared in the manufacturing of a flexographic printing raw plate, to a solution prepared at a mass ratio of ethanol/distilled water = 10/90 were added 70% by mass of Vylonal MD-2000, 20% by mass of L-7430, 5% by mass of water-dispersible aluminum hydroxide Alumina Sol 10N (manufactured by Kawaken Fine Chemicals Co., Ltd.), and 5% by mass of KF-351A followed by stirring to prepare an intermediate layer coating liquid. A flexographic printing raw plate and a flexographic printing plate were obtained under the same conditions as in Example 1 except for the above.

### [Example 13]

When the intermediate layer coating liquid described above in Manufacturing Example 4 was prepared in the manufacturing of a flexographic printing raw plate, to a solution prepared at a mass ratio of ethanol/distilled water = 10/90 were added 70% by mass of Vylonal MD-2000, 20% by mass of L-7430, 5% by mass of a carbodiimide-based crosslinking agent Carbodilite V-02 (manufactured by Nisshinbo Chemical Inc.), and 5% by mass of KF-351A followed by stirring to prepare an intermediate layer coating liquid. A flexographic printing raw plate and a flexographic printing plate were obtained under the same conditions as in Example 1 except for the above.

### [Example 14]

When the intermediate layer coating liquid described above in Manufacturing Example 4 was prepared in the manufacturing of a flexographic printing raw plate, to a solution prepared at a mass ratio of ethanol/distilled water = 10/90 were added 70% by mass of Vylonal MD-2000, 20% by mass of L-7430, 5% by mass of an isocyanate-based crosslinking agent SU-268A (manufactured by Meisei Chemical Works, Ltd.), and 5% by mass of KF-351A followed by stirring to prepare an intermediate layer coating liquid. A flexographic printing raw plate and a flexographic printing plate were obtained under the same conditions as in Example 1 except for the above.

### [Example 15]

When the intermediate layer coating liquid described above in Manufacturing Example 4 was prepared in the manufacturing of a flexographic printing raw plate, to a solution prepared at a mass ratio of ethanol/distilled water = 10/90 were added 40% by mass of the polyester emulsion PLAS COAT Z-730, 38% by mass of the polyurethane emulsion compound WLS-202, 12% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 16]

When the intermediate layer coating liquid described above in Manufacturing Example 4 was prepared in the manufacturing of a flexographic printing raw plate, to a solution prepared at a mass ratio of ethanol/distilled water = 10/90 were added 40% by mass of the polyester emulsion PLAS COAT Z-730, 38% by mass of the polyurethane emulsion compound WLS-202, 12% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 17]

When the intermediate layer coating liquid described above in Manufacturing Example 4 was prepared in the manufacturing of a flexographic printing raw plate, to a solution prepared at a mass ratio of ethanol/distilled water = 10/90 were added 70% by mass of the polyester emulsion PLAS COAT Z-730, 15% by mass of the polyurethane emulsion compound WLS-202, 5% by mass of an isocyanate-based crosslinking agent SU-268A (manufactured by Meisei Chemical Works, Ltd.), and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 18]

When the intermediate layer coating liquid described above in Manufacturing Example 4 was prepared in the manufacturing of a flexographic printing raw plate, 40% by mass of the polyester emulsion PLAS COAT Z-730, 37% by mass of the polyurethane emulsion compound WLS-202, 8% by mass of the water-swellable synthetic mica Somasif MEB-3, 5% by mass of a carbodiimide-based crosslinking agent Carbodilite V-02 (manufactured by Nisshinbo Chemical Inc.), and 10% by mass of the polyether-modified silicone oil KF-351A were added and stirred to prepare an intermediate layer coating liquid. A flexographic printing raw plate and a flexographic printing plate were obtained under the same conditions as in Example 1 except for the above.

### [Example 19]

### [Manufacturing Example 5]

### (Synthesis of polyester emulsion)

Into a 1000 ml reaction vessel provided with a stirrer, a nitrogen gas inlet, a thermometer, a rectifier, and a cooler were placed 0.01 parts by mass of a catalyst titanium tetrabutoxide and then placed as polyvalent carboxylic acid components, 146 parts by mass of dimethyl terephthalate, 20 parts by mass of dodecanedioic acid, and 32 parts by mass of trimellitic anhydride, and as polyol components, 62 parts by mass of ethylene glycol and 104 parts by mass of 2,2-dimethyl-1,3-propanediol to prepare a mixture liquid. This mixture liquid was heated to 200°C while stirred and mixed at ordinary pressure in a nitrogen atmosphere, and thereafter the temperature was gradually elevated to 250°C over 4 hours, so that transesterification reaction proceeded.

Thereafter, while this mixture liquid was stirred in the reaction vessel, the ordinary pressure was gradually reduced to 0.67 hPa (0.5 mmHg) at a temperature of 250°C. In this state, the mixture liquid was then stirred for 2 hours, so that polycondensation reaction proceeded. Polyester resin A was thereby obtained.

100 parts by mass of the obtained polyester resin A, 40 parts by mass of butyl cellosolve, 255 parts by mass of water, and 5 parts by mass of 25% ammonia water were mixed and heated at a temperature of 80 to 90°C for 2 hours with stirring to obtain polyester emulsion A in which polyester resin with a concentration of 25% by mass was dispersed. The obtained polyester emulsion A had a glass transition temperature Tg of 40°C, a number average molecular weight of 3,000, and an acid value of 55 mg KOH/g.

When the intermediate layer coating liquid described above in Manufacturing Example 4 was prepared in the manufacturing of a flexographic printing raw plate, to a solution prepared at a mass ratio of ethanol/distilled water = 10/90 were added 60% by mass of the polyester emulsion A synthesized in Manufacturing Example 5, 26% by mass of the polyurethane emulsion compound WLS-202, 4% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 20]

In the synthesis of the polyester emulsion described above in Manufacturing Example 5, into a 1000 ml reaction vessel provided with a stirrer, a nitrogen gas inlet, a thermometer, a rectifier, and a cooler were placed 0.01 parts by mass of the catalyst titanium tetrabutoxide and then placed as polyvalent carboxylic acid components, 107 parts by mass of dimethyl terephthalate, 30 parts by mass of dodecanedioic acid, and 63 parts by mass of trimellitic anhydride, and as polyol components, 62 parts by mass of ethylene glycol and 104 parts by mass of 2,2-dimethyl-1,3-propanediol to prepare a mixture liquid. Polyester resin B was obtained under the same conditions as in Manufacturing Example 5 except for the above.

100 parts by mass of this polyester resin B, 40 parts by mass of butyl cellosolve, 254 parts by mass of water, 5 parts by mass of 25% ammonia water, and 1 part by mass of sodium hydroxide were mixed and kept at a temperature of 80 to 90°C for 2 hours with stirring to obtain polyester emulsion B. The obtained polyester emulsion B had a glass transition temperature Tg of 43°C, a number average molecular weight of 3,000, and an acid value of 97 mg KOH/g.

Thereafter, when the intermediate layer coating liquid described above in Manufacturing Example 4 was prepared in the manufacturing of a flexographic printing raw plate, to a solution prepared at a mass ratio of ethanol/distilled water = 10/90 were added 60% by mass of the polyester emulsion B, 26% by mass of the polyurethane emulsion compound WLS-202, 4% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 21]

In the synthesis of the polyester emulsion described above in Manufacturing Example 5, into a 1000 ml reaction vessel provided with a stirrer, a nitrogen gas inlet, a thermometer, a rectifier, and a cooler were placed 0.01 parts by mass of the catalyst titanium tetrabutoxide and then placed as polyvalent carboxylic acid components, 161 parts by mass of dimethyl terephthalate, 20 parts by mass of dodecanedioic acid, and 15 parts by mass of trimellitic anhydride, and as polyol components, 62 parts by mass of ethylene glycol and 104 parts by mass of 2,2-dimethyl-1,3-propanediol to prepare a mixture liquid. Polyester emulsion C was obtained under the same conditions as in Manufacturing Example 5 except for the above. The obtained polyester emulsion C had a glass transition temperature Tg of 39°C, a number average molecular weight of 3,000, and an acid value of 26 mg KOH/g.

Thereafter, when the intermediate layer coating liquid described above in Manufacturing Example 4 was prepared in the manufacturing of a flexographic printing raw plate, to a solution prepared at a mass ratio of ethanol/distilled water = 10/90 were added 60% by mass of the polyester emulsion C, 26% by mass of the polyurethane emulsion compound WLS-202, 4% by mass of the water-swellable synthetic mica Somasif MEB-3, and 10% by mass of the polyether-modified silicone oil KF-351A followed by stirring to prepare an intermediate layer coating liquid. A flexographic printing raw plate and a flexographic printing plate were obtained under the same conditions as in Example 1 except for the above.

### [Example 22]

In the manufacturing of a flexographic printing raw plate, 60% by mass of the polyester emulsion compound PLAS COAT Z730, 26% by mass of the styrene-butadiene copolymer latex A-7090, 4% by mass of the water-swellable synthetic mica Somasif MEB-3, and 10% by mass of the polyether-modified silicone oil KF-351A were added and stirred to prepare an intermediate layer coating liquid. A flexographic printing raw plate and a flexographic printing plate were obtained under the same conditions as in Example 1 except for the above.

### [Example 23]

In the manufacturing of a flexographic printing raw plate, 60% by mass of the polyester emulsion compound PLAS COAT Z730, 26% by mass of an acrylonitrile-butadiene copolymer latex SX-1503A (manufactured by Zeon Corp., Tg: -26°C), 4% by mass of the water-swellable synthetic mica Somasif MEB-3, and 10% by mass of the polyether-modified silicone oil KF-351A were added and stirred to prepare an intermediate layer coating liquid. A flexographic printing raw plate and a flexographic printing plate were obtained under the same conditions as in Example 1 except for the above.

### [Example 24]

In the manufacturing of a flexographic printing raw plate, 60% by mass of the polyester emulsion compound PLAS COAT Z730, 26% by mass of a butadiene-based latex LX-111NF (manufactured by Zeon Corp., Tg: -82°C), 4% by mass of the water-swellable synthetic mica Somasif MEB-3, and 10% by mass of the polyether-modified silicone oil KF-351A were added and stirred to prepare an intermediate layer coating liquid. A flexographic printing raw plate was obtained under the same conditions as in Example 1 except for the above.

Thereafter, in the manufacturing process of a flexographic printing plate, the cover sheet of the infrared ablation layer was peeled, a halftone image (AM 150 lpi, data 25% halftone) was drawn on the infrared ablation layer using CDI Crystal 4835 (manufactured by ESKO Graphics Co., Ltd., trade name) on a pixel+ mode.

After drawing, both faces on the infrared ablation side and the support side were exposed using XPS Crystal 4835 (manufactured by ESKO Graphics Co., Ltd., trade name) under conditions set to Main UV Power Density of 311 mW/cm², Back UV Power Density of 27 mW/cm², four passes, and a pixel time of 20 seconds.

After exposure, 1% polyoxyalkylene alkyl ether (NEWCOL 2308: manufactured by Nippon Nyukazai Co., Ltd.) was prepared, and an unexposed part was removed by washing (development) at 40°C using a cleaning machine manufactured by Nihon Denshi Seiki Co., Ltd. (JOW-A3-P). After drying at 50°C for 10 minutes, post exposure was performed with an ultraviolet sterilization lamp and an ultraviolet chemical lamp for removal of surface tackiness to obtain a flexographic printing plate.

### [Example 25]

In the manufacturing of a flexographic printing raw plate, 80% by mass of the polyester emulsion compound PLAS COAT Z730, 15% by mass of water-soluble polyamide AQ Nylon T-70 (manufactured by Toray Industries, Inc.), and 5% by mass of the polyether-modified silicone oil KF-351A were added and stirred to prepare an intermediate layer coating liquid. A flexographic printing raw plate and a flexographic printing plate were obtained under the same conditions as in Example 1 except for the above.

### [Example 26]

In the manufacturing of a photosensitive resin composition, after mixing 60 parts by mass of a styrene-butadiene-styrene copolymer [D-KX405: manufactured by Kraton Corporation] at 180°C using a pressure kneader, a liquid mixture of 32 parts by mass of a liquid polybutadiene [LBR-352: manufactured by Kuraray Co., Ltd.], 8 parts by mass of 1,9-nonanediol diacrylate, 5 parts by mass of 1,6-hexanediol dimethacrylate, 2 parts by mass of 2,2-dimethoxy-phenylacetophenone, 1 part by mass of 2,6-di-t-butyl-p-cresol, and 1 part by mass of amino-modified silicone oil [KF-8000: manufactured by Shin-Etsu Chemical Co., Ltd.] was added little by little over 15 minutes, and additional kneading was carried out for 20 minutes after completion of addition to obtain photosensitive resin composition 2. A flexographic printing raw plate was obtained under the same conditions as in Example 8 except for the above.

Thereafter, the flexographic printing raw plate was exposed from the side of the support (PET coated with an adhesive) using an ultraviolet light exposure apparatus "JE-A2-SS" (manufactured by Nihon Denshi Seiki Co., Ltd., trade name) so that a pattern height (RD) after curing was about 0.5 mm.

Thereafter, the cover sheet of the infrared ablation layer was peeled, a halftone image (AM 150 lpi, data 25% halftone) was drawn on the infrared ablation layer using CDI Spark 4260 (manufactured by ESKO Graphics Co., Ltd., trade name), and the infrared ablation layer side was exposed at 8000 mJ under an air atmosphere using the above-described exposure apparatus.

After exposure, a double-faced tape was attached to the side subjected to the back exposure mentioned above, which was then fixed to a rotating drum of "AFP-1500" developing machine (manufactured by Asahi Kasei Corp., trade name), and development was conducted at a liquid temperature of 25°C for 5 minutes with 3-methoxybutyl acetate as a developer, followed by drying at 60°C for 2 hours. Post exposure was performed with an ultraviolet sterilization lamp and an ultraviolet chemical lamp for removal of surface tackiness to obtain a flexographic printing plate.

### [Example 27]

A flexographic printing raw plate was obtained in the same manner as in Example 19 described above. Thereafter, the flexographic printing raw plate was exposed from the side of the support (PET coated with an adhesive) using an ultraviolet light exposure apparatus "JE-A2-SS" (manufactured by Nihon Denshi Seiki Co., Ltd., trade name) so that a pattern height (RD) after curing was about 0.5 mm.

Thereafter, the cover sheet of the infrared ablation layer was peeled, a halftone image (AM 150 lpi, data 25% halftone) was drawn on the infrared ablation layer using CDI Spark 4260 (manufactured by ESKO Graphics Co., Ltd., trade name), and the infrared ablation layer side was exposed at 8000 mJ under an air atmosphere using the above-described exposure apparatus.

After exposure, the flexographic printing raw plate was heated to 170°C in CYREL(R) FAST TD1000 heat processor and brought into contact with a developing medium to remove an unexposed part. The developing medium was nonwoven polyester.

Post exposure was performed with an ultraviolet sterilization lamp and an ultraviolet chemical lamp for removal of surface tackiness to obtain a flexographic printing plate.

### [Comparative Example 1]

When the intermediate layer coating liquid described above in Manufacturing Example 4 was prepared in the manufacturing of a flexographic printing raw plate, to a solution prepared at a mass ratio of ethanol/distilled water = 10/90 were added 50% by mass of a polyester emulsion compound Vylonal MD-1400 (manufactured by Toyobo Co., Ltd., Tg: 20°C), and 50% by mass of polyvinyl alcohol GOSENOL KL-03 (manufactured by The Nippon Synthetic Chemical Industry Co., Ltd.) followed by stirring to prepare an intermediate layer coating liquid. A flexographic printing raw plate and a flexographic printing plate were obtained under the same conditions as in Example 1 except for the above.

### [Comparative Example 2]

When the intermediate layer coating liquid described above in Manufacturing Example 4 was prepared in the manufacturing of a flexographic printing raw plate, to a solution prepared at a mass ratio of ethanol/distilled water = 10/90 were added 50% by mass of a styrene-butadiene copolymer latex (emulsion compound) XL-006 (manufactured by Asahi Kasei Corp., Tg: -6°C), 40% by mass of WLS-202, and 10% by mass of KF-351A followed by stirring to prepare an intermediate layer coating liquid. A flexographic printing raw plate and a flexographic printing plate were obtained under the same conditions as in Example 1 except for the above.

### [Comparative Example 3]

When the intermediate layer coating liquid described above in Manufacturing Example 4 was prepared in the manufacturing of a flexographic printing raw plate, to a solution prepared at a mass ratio of ethanol/distilled water = 10/90 were added 20% by mass of an acrylonitrile-butadiene copolymer latex (emulsion compound) SX1503 (manufactured by Zeon Corp., Tg: -26°C), 50% by mass of polyvinyl alcohol PVA405 (manufactured by Kuraray Co., Ltd.), and 30% by mass of aliphatic polyhydric alcohol-based polyether polyol Sunflex SE270 (manufactured by Sanyo Chemical Industries, Ltd.) followed by stirring to prepare an intermediate layer coating liquid. A flexographic printing raw plate and a flexographic printing plate were obtained under the same conditions as in Example 1 except for the above.

### [Comparative Example 4]

When the intermediate layer coating liquid described above in Manufacturing Example 4 was prepared in the manufacturing of a flexographic printing raw plate, to a solution prepared at a mass ratio of ethanol/distilled water = 10/90 were added 10% by mass of L-7430, 75% by mass of AQ Nylon T-70, 5% by mass of water-swellable synthetic mica Somasif MEB-3 (manufactured by Katakura & Co-op Agri Corp.), and 10% by mass of KF-351A followed by stirring to prepare an intermediate layer coating liquid. A flexographic printing raw plate and a flexographic printing plate were obtained under the same conditions as in Example 1 except for the above.

### [Comparative Example 5]

When the intermediate layer described above in Manufacturing Example 4 was applied in the manufacturing of a flexographic printing raw plate, to a solution prepared at a mass ratio of ethanol/distilled water = 10/90 was added 100% by mass of the polyester emulsion compound PLAS COAT Z-221 followed by stirring to prepare an intermediate layer coating liquid. A flexographic printing raw plate and a flexographic printing plate were obtained under the same conditions as in Example 1 except for the above.

### [Comparative Example 6]

When the intermediate layer coating liquid described above in Manufacturing Example 4 was prepared in the manufacturing of a flexographic printing raw plate, to a solution prepared at a mass ratio of toluene/methyl ethyl ketone = 50/50 were added 20% by mass of co-polyester resin Vylon 200 (manufactured by Toyobo Co., Ltd.), and 80% by mass of co-polyester resin Vylon 300 (manufactured by Toyobo Co., Ltd.) followed by stirring to prepare an intermediate layer coating liquid. Thereafter, the intermediate layer coating liquid was applied, so that the film thickness after drying became 0.7 µm. A flexographic printing raw plate and a flexographic printing plate were obtained under the same conditions as in Example 1 except for the above.

### [Comparative Example 7]

When the intermediate layer described above in Manufacturing Example 4 was applied in the manufacturing of a flexographic printing raw plate, to a solution prepared at a mass ratio of ethanol/distilled water = 10/90 were added 67% by mass of a polyester emulsion compound PLAS COAT Z-446 (manufactured by Goo Chemical Co., Ltd., Tg: 47°C, number average molecular weight: 16,000, acid value: < 5 mg KOH/g), and 33% by mass of a polyvinylpyrrolidone solution K60 (manufactured by Sigma-Aldrich Co., LLC) followed by stirring to prepare an intermediate layer coating liquid. A flexographic printing raw plate and a flexographic printing plate were obtained under the same conditions as in Example 1 except for the above.

### [Measurement of physical property]

### <Measurement method of tensile stress-strain curve diagram>

### 1. Production of sample

The flexographic printing raw plate was exposed at 8,000 mJ from the side of the support (PET coated with an adhesive) using an ultraviolet light exposure apparatus "JE-A2-SS" (manufactured by Nihon Denshi Seiki Co., Ltd., trade name).

Thereafter, the cover sheet of the infrared ablation layer was peeled, and the entire surface of the infrared ablation layer was removed using CDI Spark 4260 (manufactured by ESKO Graphics Co., Ltd., trade name) to expose the intermediate layer.

Thereafter, the resultant was immersed in any solvent capable of dissolving the composition among distilled water, a distilled water-ethanol mixture liquid, and an organic solvent, and ultrasonic extraction was performed for 30 minutes. The extract was dried to obtain a dried intermediate layer composition.

The obtained dried intermediate layer composition was sandwiched between two PET films with a thickness of 100 µm subjected to mold release treatment, and molded into a thickness of 100 µm in a press heated to 150°C.

The obtained molded product was punched with a tensile dumbbell shape No. 8 punching blade (manufactured by Kobunshi Keiki Co., Ltd.) with a thickness of 100 µm in accordance with JIS K 6251 (2017) to prepare a test specimen.

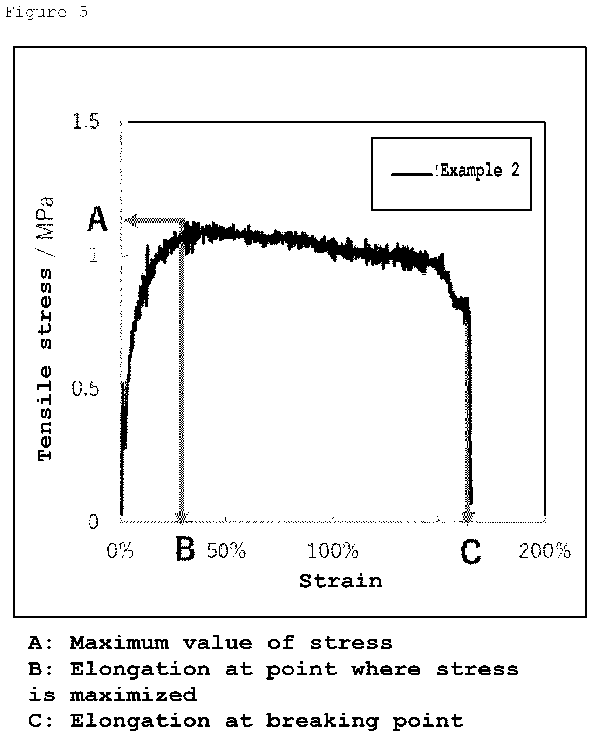

The tensile stress-strain curve diagram of Examples 2 and 6 and Comparative Example 1 obtained as described above is collectively shown in Figure 4, and the respective tensile stress-strain curve diagrams of Examples 2 and 6 and Comparative Example 1 are shown in Figures 5 to 7.

### 2. Apparatus, measurement conditions, etc.

This test specimen was subjected to a tensile breaking test in a desktop precision universal tester (manufactured by Shimadzu Corp., Autograph AGS-X) under conditions involving a crosshead speed of 200 mm/min and a distance of 30 mm between chucks. The data was recorded on attached software (TRAPEZIUM LITE X). Measurement was carried out at n = 5, and an average value thereof was adopted. A representative measurement example is shown in Figure x.

### <Measurement of water contact angle>

### 1. Production of sample

The flexographic printing raw plate was exposed at 8,000 mJ from the side of the support (PET coated with an adhesive) using an ultraviolet light exposure apparatus "JE-A2-SS" (manufactured by Nihon Denshi Seiki Co., Ltd., trade name).

Thereafter, the cover sheet of the infrared ablation layer was peeled, and the entire surface of the infrared ablation layer was removed using CDI Spark 4260 (manufactured by ESKO Graphics Co., Ltd., trade name) to expose the intermediate layer.

### 2. Apparatus, measurement conditions, etc.

To the exposed intermediate layer was added dropwise 0.2 mL of distilled water using contact angle meter AD-31 (manufactured by Kyowa Interface Science Co., Ltd.), and the intermediate layer was left standing for 3 minutes after dropwise addition, followed by contact angle measurement at n = 5 or more. An average value thereof was adopted.

### <Tg measurement method of emulsion compound>

The glass transition temperature Tg of an emulsion compound refers to a value measured by DSC in accordance with JIS K 7121 (1987) and specifically refers to a glass transition temperature (Tg) obtained by placing the emulsion compound in a differential scanning calorimeter, elevating the temperature to (Tg + 50°C) at a temperature elevation rate of 10°C/min, then keeping the temperature for 10 minutes, then rapidly cooling the compound, and reading a value from the obtained differential thermal curve.

A commercially available product can be used as the emulsion compound. For a commercially available product of the emulsion compound, a catalog data of the commercially available product is preferentially adopted as Tg. Although Tables 1 to 3 described below do not show a unit for the sake of convenience, the unit of Tg is Celsius (°C) .

### <Measurement method of number average molecular weight (Mn) by gel permeation chromatography (GPC)>

### 1. Preparation of sample

To 0.1 g of an emulsion compound prepared at a solid content of 20% by mass by the addition of water, if necessary, is added about 1 g of cation-exchange resin cleaned and washed with water in accordance with a routine method, to remove cations. 50 ml of tetrahydrofuran is added to the compound, which is then left for 2 hours and dissolved. Thereafter, the solution is filtered through a polytetrafluoroethylene membrane filter (pore size: 3 µm, manufactured by ADVANTEC), and the filtrate is used as a measurement sample.

### 2. Apparatus, measurement conditions, etc.

GPC measurement of the emulsion compound was carried out using an apparatus and measurement conditions given below. When the obtained GPC chart is bimodal, the largest number average molecular weight is adopted in the present embodiment.
Apparatus: HLC-8220 GPC manufactured by Tosoh Corp.
Column: the following four columns were connected in series for separation.
   TSKgel GMH XL manufactured by Tosoh Corp.
   TSKgel GMH XL manufactured by Tosoh Corp.
   TSKgel GMH XLL manufactured by Tosoh Corp.
   TSKgel GMH XLL manufactured by Tosoh Corp.
Column temperature: 40°C
Solvent: tetrahydrofuran
Flow rate: 1 mL/min
Detector: RI
Calibration curve: standard polystyrene

### [Characteristic evaluation]

### <Evaluation of developing performance>

The flexographic printing raw plate obtained in each of Examples 1 to 27 and Comparative Examples 1 to 7 was developed at 40°C with an aqueous solution of 1% polyoxyalkylene alkyl ether (NEWCOL 2308: manufactured by Nippon Nyukazai Co., Ltd.) and 1% potassium carbonate as a developer using a cleaning machine manufactured by Nihon Denshi Seiki Co., Ltd. (JOW-A3-P). The removal status of the infrared ablation layer and the intermediate layer was confirmed after development times of 20 seconds, 40 seconds, 60 seconds, and 180 seconds.

The flexographic printing raw plate obtained in Example 19 was developed by the method described in Example 19, and the removal status of the infrared ablation layer and the intermediate layer was confirmed after development times of 20 seconds, 40 seconds, 60 seconds, and 180 seconds.

The flexographic printing raw plate obtained in Example 20 was developed by the method described in Example 20, and the removal status of the infrared ablation layer and the intermediate layer was confirmed after development times of 20 seconds, 40 seconds, 60 seconds, and 180 seconds.

Developing performance was evaluated on the basis of a cleaning time required for uniformly removing the infrared ablation layer and the intermediate layer according to an evaluation scale given below. Those given a score of 3 or more on the following evaluation scale can be practically used without any problem.

### (Evaluation scale)

5: The cleaning time required for removal is 20 seconds or shorter.
4: The cleaning time required for removal is longer than 20 seconds and 40 seconds or shorter.
3: The cleaning time required for removal is longer than 40 seconds and 60 seconds or shorter.
2: The cleaning time required for removal is longer than 60 seconds and 180 seconds or shorter.
1: The cleaning time required for removal is longer than 180 seconds, or uniform removal is not attained.

### <Plate reproducibility: evaluation of uneven size of halftone image>

Two samples of the flexographic printing raw plate obtained in each of Examples and Comparative Examples were provided. One of the samples was stored for 7 days in constant temperature and humidity bath PH-3K (manufactured by ESPEC Corp.) set to a temperature of 30°C and a relative humidity of 10% RH, and the other sample was stored for 1 month in the constant temperature and humidity bath PH-3K set to a temperature of 30°C and a relative humidity of 90% RH. Thereafter, a flexographic printing plate was obtained by the same method as the manufacturing method of a flexographic printing plate described in Example 1.

The top area ratio (AM 150 lpi, 25% halftone site) of the halftone image part on the obtained flexographic printing plate was measured at n = 20 of varying measurement sites in FLEX3PRO (manufactured by Avid Flex Co., Ltd.). Thereafter, plate reproducibility was evaluated on the basis of the difference in the average area ratio of the top of the halftone between the two samples differing in storage environment according to an evaluation scale given below. Those given a score of 3 or more on the following evaluation scale can be practically used without any problem.

### (Evaluation scale)

5: The difference in the area ratio of the top of the halftone is 0.2% or less.
4: The difference in the area ratio of the top of the halftone is more than 0.2% and 0.3% or less.
3: The difference in the area ratio of the top of the halftone is more than 0.3% and 0.6% or less.
2: The difference in the area ratio of the top of the halftone is more than 0.6% and 1.0% or less.
1: The difference in the area ratio of the top of the halftone is more than 1.0% and 2.0% or less.
0: The difference in the area ratio of the top of the halftone is more than 2.0%.

### <Evaluation of reattachment of scum of ablation layer to plate surface>

The flexographic printing raw plate obtained in each of Examples and Comparative Examples was stored for 1 month in constant temperature and humidity bath PH-3K set to a temperature of 30°C and a relative humidity of 90% RH. Thereafter, a flexographic printing plate was manufactured by the same method as the manufacturing method of a flexographic printing plate described in Example 1 using the flexographic printing raw plate.

The halftone image part of the obtained flexographic printing plate was observed in a 20 cm × 20 cm field of view at a magnification of 50× in a microscope (manufactured by Keyence Corp., VHX-1000), and the number of attaching scums of the infrared ablation layer was counted. The reattachment property of scums of the ablation layer to the plate surface was evaluated on the basis of the counted number of scums according to an evaluation scale given below. Those given a score of 3 or more on the following evaluation scale can be practically used without any problem.

### (Evaluation scale)

5: No scum of the infrared ablation layer attaches.
4: The number of attaching scums of the infrared ablation layer is 2 or less.
3: The number of attaching scums of the infrared ablation layer is 3 or more and 5 or less.
2: The number of attaching scums of the infrared ablation layer is 6 or more and 10 or less.
1: The number of attaching scums of the infrared ablation layer is 11 or more.

### <Pinhole (PH) evaluation>

The flexographic printing raw plate obtained in each of [Examples] and [Comparative Examples] was cut into a size of 20 cm × 20 cm to prepare five samples.

After removing of the cover film of the infrared ablation layer, each of these samples was wound on a drum of a laser ablation device (CDI Sperk 2530), left standing for 10 minutes, and then observed in a 20 cm × 20 cm field of view at a magnification of 50× in a microscope (manufactured by Keyence Corp., VHX-1000). The numbers of pinholes with a size of 20 µm or more in a longer diameter were counted in the infrared ablation layer and averaged, and the value of (number/m2) was calculated and evaluated according to 1 to 5 given below. A larger numeral in the following evaluation is preferable, and those given a score of 3 or more can be practically used without any problem.
5: The number of pinholes is less than 2 (number/m2) on average.
4: The number of pinholes is 2 (number/m2) or more and less than 5 (number/m2) on average.
3: The number of pinholes is 5 (number/m2) or more and less than 10 (number/m2) on average.
2: The number of pinholes is 10 (number/m2) or more and less than 20 (number/m2) on average.
1: The number of pinholes is 20 (number/m2) or more on average.

The results of each evaluation described above are shown in Tables 1 to 3 below.

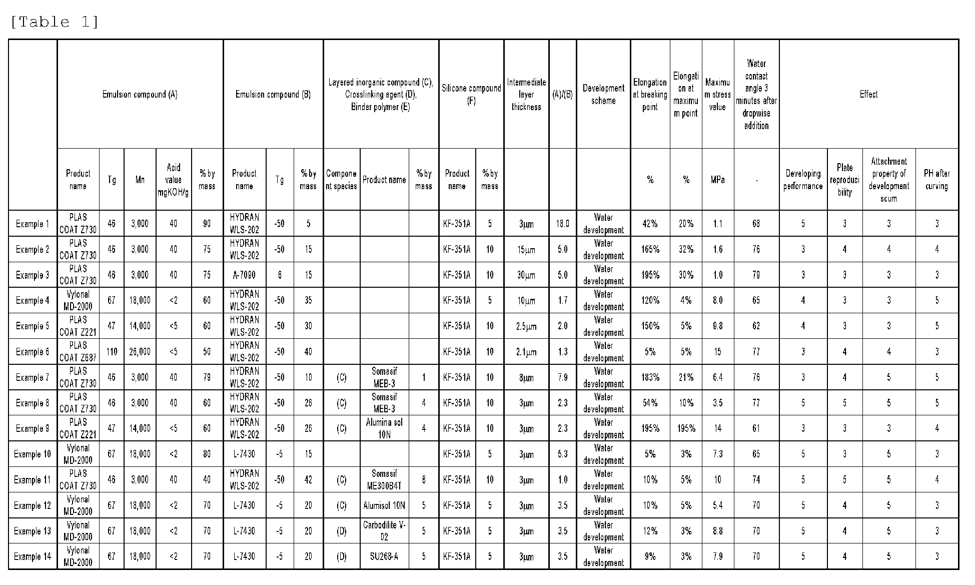

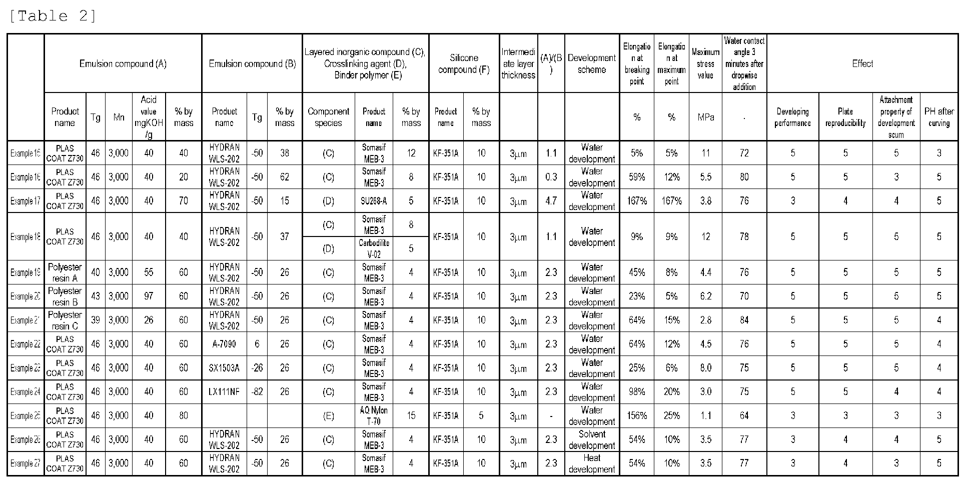

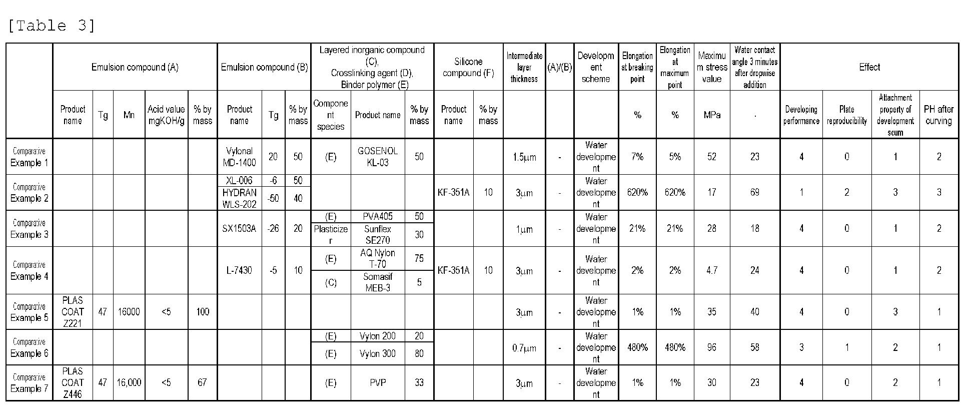

### (Component)

The following was used as each component described in the tables.

### <Emulsion compounds (A) and (B)>

Vylonal MD-2000: polyester emulsion, manufactured by Toyobo Co., Ltd.
Vylonal MD-1400: polyester emulsion, manufactured by Toyobo Co., Ltd.
PLAS COAT Z221: polyester emulsion, manufactured by Goo Chemical Co., Ltd.
PLAS COAT Z446: polyester emulsion, manufactured by Goo Chemical Co., Ltd.
PLAS COAT Z730: polyester emulsion, manufactured by Goo Chemical Co., Ltd.
PLAS COAT Z687: polyester emulsion, manufactured by Goo Chemical Co., Ltd.
A-7090: styrene-butadiene copolymer latex, manufactured by Asahi Kasei Corp.
L-7430: styrene-butadiene copolymer latex, manufactured by Asahi Kasei Corp.
XL-006: styrene-butadiene copolymer latex, manufactured by Asahi Kasei Corp.
HYDRAN WLS-202 : polyurethane emulsion, manufactured by DIC Corp.
SX1503A: acrylonitrile-butadiene copolymer latex, manufactured by Zeon Corp.
LX-111NF: polybutadiene latex, manufactured by Zeon Corp.

### <Layered inorganic compound (C)>

Somasif MEB-3: mica, manufactured by Katakura & Co-op Agri Corp.
Somasif ME300B4T: mica, manufactured by Katakura & Co-op Agri Corp.
Alumisol 10N: aluminum oxide, manufactured by Kawaken Fine Chemicals Co., Ltd.

### <Crosslinking agent (D)>

Carbodilite V-02: carbodiimide-based crosslinking agent, manufactured by Nisshinbo Chemical Inc.
SU268-A: isocyanate-based crosslinking agent, manufactured by Meisei Chemical Works, Ltd.

### <Binder polymer (E)>

AQ Nylon T-70: polyamide, manufactured by Toray Industries, Inc.
GOSENOL KL-03: polyvinyl alcohol, manufactured by The Nippon Synthetic Chemical Industry Co., Ltd.
PVA405: polyvinyl alcohol, manufactured by Kuraray Co., Ltd.
Vylon 200: co-polyester resin, manufactured by Toyobo Co., Ltd.
Vylon 300: co-polyester resin, manufactured by Toyobo Co., Ltd.
Sunflex SE270: polyalkylene glycol, manufactured by Sanyo Chemical Industries, Ltd.
PVP: Polyvinylpyrrolidone Solution K60, manufactured by Sigma-Aldrich Co., LLC

### <Silicone compound (F)>

KF-351A: polyether-modified silicone oil, manufactured by Shin-Etsu Chemical Co., Ltd.

### Industrial Applicability

The present invention has industrial applicability as a flexographic printing raw plate for obtaining a flexographic printing plate.

## Claims

1. A flexographic printing raw plate comprising:
a support;
a photosensitive resin composition layer on the support;
an intermediate layer; and
an infrared ablation layer in the presented order, wherein
in a tensile stress-strain curve diagram measured by molding the intermediate layer into dumbbell shape No. 8 with a thickness of 100 µm in accordance with JIS K 6251 (2017),
an elongation at a breaking point is 5% or more and 200% or less,
an elongation at a point where the stress is maximized is 3% or more and 200% or less, and
a maximum value of the stress is 1.0 MPa or more and 15 MPa or less.

2. The flexographic printing raw plate according to claim 1, wherein
the intermediate layer has a water contact angle of 60° or more and 90° or less 3 minutes after dropwise addition at an interface with the infrared ablation layer.

3. The flexographic printing raw plate according to claim 1 or 2, wherein
the intermediate layer has a water contact angle of 70° or more 3 minutes after dropwise addition at an interface with the infrared ablation layer.

4. A flexographic printing raw plate comprising:
a support;
a photosensitive resin composition layer on the support;
an intermediate layer; and
an infrared ablation layer in the presented order, wherein
the intermediate layer has a water contact angle of 70° or more and 90° or less 3 minutes after dropwise addition at an interface with the infrared ablation layer.

5. The flexographic printing raw plate according to any one of claims 1 to 4, wherein
the intermediate layer comprises 10% by mass or more and 95% by mass or less of an emulsion compound (A) having a glass transition temperature (Tg) of 30°C or higher based on the total amount of the intermediate layer.

6. The flexographic printing raw plate according to claim 5, wherein
an acid value of the emulsion compound (A) is 20 mg KOH/g or more and 100 mg KOH/g or less.

7. The flexographic printing raw plate according to claim 5 or 6, wherein
a number average molecular weight of the emulsion compound (A) is 2,000 or more and 50,000 or less.

8. The flexographic printing raw plate according to any one of claims 1 to 7, wherein
the emulsion compound (A) comprises a polyester emulsion.

9. The flexographic printing raw plate according to claim 8, wherein
the emulsion compound (A) is a co-polyester emulsion comprising an aromatic polyvalent carboxylic acid component as a copolymer component and having a carboxyl group and/or a sulfonate group.

10. The flexographic printing raw plate according to any one of claims 1 to 9, wherein
the intermediate layer further comprises 10% by mass or more and 70% by mass or less of an emulsion compound (B) having a glass transition temperature (Tg) of 10°C or lower based on the total amount of the intermediate layer.

11. The flexographic printing raw plate according to claim 10, wherein
the emulsion compound (B) is at least one emulsion compound selected from the group consisting of a polyurethane emulsion, a polybutadiene latex, a styrene-butadiene copolymer latex, and an acrylonitrile-butadiene copolymer latex.

12. The flexographic printing raw plate according to claim 10 or 11, wherein
a ratio of the emulsion compound (A) to the emulsion compound (B) is 1.0 or more and 2.3 or less.

13. The flexographic printing raw plate according to any one of claims 1 to 12, wherein
the intermediate layer further comprises a layered inorganic compound (C).

14. The flexographic printing raw plate according to any one of claims 1 to 13, wherein
the intermediate layer further comprises a crosslinking agent (D).

15. The flexographic printing raw plate according to any one of claims 1 to 14, wherein
a thickness of the intermediate layer is larger than 2 µm and 30 µm or less.

16. A manufacturing method of a flexographic printing plate, comprising:
an infrared irradiation step of producing a negative pattern by subjecting the infrared ablation layer of the flexographic printing raw plate according to any one of claims 1 to 15 to laser ablation;
an exposure step of selectively exposing the photosensitive resin composition layer through the negative pattern; and
a development step of removing an unexposed part of the photosensitive resin composition layer.

17. A flexographic printing method comprising:
a printing plate manufacturing step of manufacturing a flexographic printing plate by the manufacturing method of a flexographic printing plate according to claim 16; and
a step of performing printing using the flexographic printing plate manufactured in the printing plate manufacturing step.
